# EUROPEAN PATENT APPLICATION

(11) **EP 2 505 695 A2**
(43) Date of publication of application: **03.10.2012**
(21) Application number: 12174515.2
(22) Date of filing: 16.07.2008
(51) Int. Cl.: C30B 29/06, C30B 11/14, H01L 31/18

(54) **Methods for manufacturing cast silicon from seed crystals**

(30) Priority: 20.07.2007 US 951155 P; 20.07.2007 US 951151 P
(62) Divisional of application: 08781897.7
(71) Applicant: AMG Idealcast Solar Corporation, Frederick, MD 21703 (US)
(72) Inventor: Stoddard, Nathan, G., Gettysburg, PA Pennsylvania 17325 (US)
(74) Representative: Derks, Wilbert

(57) **Abstract**

Methods are provided for casting silicon for photovoltaic cells and other applications. With such methods a cast body of bi-crystal silicon may be formed that is free of, or substantially free of, radially-distributed impurities and defects and having at least two dimensions that are each at least about 35 cm is provided.

## Description

This application claims the benefit of U.S. Provisional Application No.: 60/951,151, filed July 20, 2007. The entire disclosure of U.S. Provisional Application No.: 60/951,151 is hereby incorporated by reference into this specification. This application also claims the benefit of U.S. Provisional Application No.: 60/951,155, filed July 20, 2007. The entire disclosure of U.S. Provisional Application No.: 60/951,155 is hereby incorporated by reference into this specification.

### DESCRIPTION

### TECHNICAL FIELD

The present invention generally relates to the field of photovoltaics and to methods and apparatuses for manufacturing cast silicon for photovoltaic applications. The invention further relates to new forms of cast silicon that can be used to manufacture devices, such as photovoltaic cells and other semiconductor devices. The new silicon can have a monocrystalline, near-monocrystalline, or bi-crystal structure and can be manufactured by a casting process utilizing seed crystals.

### BACKGROUND INFORMATION

Photovoltaic cells convert light into electric current. One of the most important measures of a photovoltaic cell is its efficiency in converting light energy into electrical energy. Although photovoltaic cells can be fabricated from a variety of semiconductor materials, silicon is generally used because it is readily available at reasonable cost, and because it has a suitable balance of electrical, physical, and chemical properties for use in fabricating photovoltaic cells.

In a known procedure for the manufacture of photovoltaic cells, silicon feedstock is mixed with a material (or dopant) for inducing either a positive or negative conductivity type, melted, and then crystallized by either pulling crystallized silicon out of a melt zone into ingots of monocrystalline silicon (via the Czochralski (CZ) or float zone (FZ) methods), or cast into blocks or "bricks" of multi-crystalline silicon or polycrystalline silicon, depending on the grain size of the individual silicon grains. In the procedure described above, the ingots or blocks are cut into thin substrates, also referred to as wafers, by known slicing or sawing methods. These wafers may then be processed into photovoltaic cells.

Monocrystalline silicon for use in the manufacture of photovoltaic cells is generally produced by the CZ or FZ methods, both being processes in which a cylindrically shaped boule of crystalline silicon is produced. For a CZ process, the boule is slowly pulled out of a pool of molten silicon. For a FZ process, solid material is fed through a melting zone and re-solidified on the other side of the melting zone. A boule of monocrystalline silicon, manufactured in these ways, contains a radial distribution of impurities and defects, such as rings of oxygen-induced stacking faults (OSF) and "swirl" defects of interstitial or vacancy clusters. Even with the presence of these impurities and defects, monocrystalline silicon is generally a preferred source of silicon for producing photovoltaic cells, because it can be used to produce high efficiency solar cells. Monocrystalline silicon is, however, more expensive to produce than conventional multi-crystalline silicon, using known techniques such as those described above.

Conventional multi-crystalline silicon for use in the manufacture of photovoltaic cells is generally produced by a casting process. Casting processes for preparing conventional multi-crystalline silicon are known in the art of photovoltaic technology. Briefly, in such processes, molten silicon is contained in a crucible, such as a quartz crucible, and is cooled in a controlled manner to permit the crystallization of the silicon contained therein. The block of multi-crystalline silicon that results is generally cut into bricks having a cross-section that is the same as or close to the size of the wafer to be used for manufacturing a photovoltaic cell, and the bricks are sawed or otherwise cut into such wafers. The multi-crystalline silicon produced in such manner is an agglomeration of crystal grains where, within the wafers made therefrom, the orientation of the grains relative to one another is effectively random.

The random orientation of grains, in either conventional multi-crystalline or poly-crystalline silicon, makes it difficult to texture the surface of a resulting wafer. Texturing is used to improve efficiency of a photovoltaic cell, by reducing light reflection and improving light energy absorption through the surface a cell. Additionally, "kinks" that form in the boundaries between the grains of conventional multi-crystalline silicon tend to nucleate structural defects in the form of clusters or lines of dislocations. These dislocations, and the impurities they tend to attract, are believed to cause a fast recombination of electrical charge carriers in a functioning photovoltaic cell made from conventional multi-crystalline silicon. This can cause a decrease in the efficiency of the cell. Photovoltaic cells made from such multi-crystalline silicon generally have lower efficiency compared to equivalent photovoltaic cells made from monocrystalline silicon, even considering the radial distribution of defects present in monocrystalline silicon produced by known techniques. However, because of the relative simplicity and lower costs for manufacturing conventional multi-crystalline silicon, as well as effective defect passivation in cell processing, multi-crystalline silicon is a more widely used form of silicon for manufacturing photovoltaic cells.

Some previous casting techniques involved using a "cold-wall" crucible for crystal growth. The term "cold-wall" refers to the fact that induction coils present on or in the walls of the crucible are water cooled, and may also be slotted, thus generally remaining below 100 °C. The crucible walls may be situated in close proximity between the coils and the feedstock. The material of the crucible walls is not particularly thermally insulating, and can therefore remain in thermal equilibrium with the cooled coils. The heating of the silicon is therefore not predicated on radiation from the crucible walls, because inductive heating of the silicon in the crucible means that the silicon is heated directly by current induced to flow therein. In this way, the walls of the crucible remain below the melting temperature of the silicon, and are considered "cold," relative to the molten silicon. During solidification of the inductively heated molten silicon, these cold walls of the crucible act as a heat sink. The ingot cools quickly, determined by radiation to the cold walls. Therefore, an initial solidification front quickly becomes substantially curved, with crystal nucleation occurring at the ingot sides and growing diagonally towards the ingot center, disrupting any attempt at maintaining a vertical and geometrically ordered seeding process or a substantially flat solidification front.

### SUMMARY OF THE INVENTION

According to some embodiments, this invention relates to a method and apparatus of using seed crystals to manufacture cast silicon. Typically, silicon crystals of different orientations grow at different rates during solidification of a silicon ingot. A desirable orientation for silicon single-crystal solar cell manufacture is the (100) direction, due to its convenient formation of a light-trapping surface with etching processes. Unfortunately, (100) oriented grains perform poorly during crystallization in competition with randomly nucleated grains, such as during a single crystal casting process where the other oriented grains grow faster.

According to some embodiments and in order to maximize the seeded crystalline volume in an ingot, a border of (111) oriented silicon surrounds a (100) oriented seed area. The border competes very successfully against other crystal orientations. In this way, an ingot with highly performing single crystal and/or bi-crystal bricks can be cast that maximizes the minority carrier lifetime of the resulting wafers for use in high efficiency solar cells.

As used herein, the term "monocrystalline silicon" refers to a body of single crystal silicon, having one consistent crystal orientation throughout. Further, conventional multi-crystalline silicon refers to crystalline silicon having cm-scale grain size distribution, with multiple randomly oriented crystals located within a body of silicon.

Further, as used herein, the term "poly-crystalline silicon" refers to crystalline silicon with micron order grain size and multiple grain orientations located within a given body of silicon. For example, the grains are typically an average of about submicron to submillimeter in size (e.g., individual grains may not be visible to the naked eye), and grain orientation distributed randomly throughout.

Still further, as used herein, the term "near-monocrystalline silicon" refers to a body of crystalline silicon, having one consistent crystal orientation throughout for greater than 50% by volume of the body, where, for example, such near-monocrystalline silicon may comprise a body of single crystal silicon next to a multicrystalline region, or it may comprise a large, contiguously consistent crystal of silicon that partially or wholly contains smaller crystals of silicon of other crystal orientations, where the smaller crystals do not make up more than 50% of the overall volume. Preferably, the near-monocrystalline silicon may contain smaller crystals which do not make up more than 25% of the overall volume. More preferably, the near-monocrystalline silicon may contain smaller crystals which do not make up more than 10% of the overall volume. Still more preferably, the near-monocrystalline silicon may contain smaller crystals which do not make up more than 5% of the overall volume.

Still further, as used herein, the term "bi-crystal silicon" refers to a body of silicon, having one consistent crystal orientation throughout for greater than or equal to 50% by volume of the body, and another consistent crystal orientation for the remainder of the volume of the body. For example, such bi-crystal silicon may comprise a body of single crystal silicon having one crystal orientation next to another body of single crystal silicon having a different crystal orientation making up the balance of the volume of crystalline silicon. Preferably, the bi-crystal silicon may contain two discrete regions within the same body of silicon, the regions differing only in their crystal orientation.

As used herein, however, the term "geometrically ordered multi-crystalline silicon" (hereinafter abbreviated as "geometric multi-crystalline silicon") refers to crystalline silicon, according to embodiments of the present invention, having a geometrically ordered cm-scale grain size distribution, with multiple ordered crystals located within a body of silicon. For example, in geometric multi-crystalline silicon, each grain typically has an average cross-sectional area of about 0.25 cm² to about 2,500 cm² in size, and a height that can be as large as the body of silicon, for example, the height can be as large as the dimension of the body of silicon that is perpendicular to the plane of the cross-section, with grain orientation within a body of geometric multi-crystalline silicon being controlled according to predetermined orientations. The shape of the cross-section of the grain that is perpendicular to the height or length of the grain of geometric multi-crystalline silicon is typically the same as the shape of the seed crystal or part of a seed crystal over which it was formed. Preferably, the shape of the cross-section of the grain is polygonal. Preferably, the corners of the polygonal grains correspond to junctions of three different grains. Although each grain within a body of geometric multi-crystalline silicon preferably comprises silicon having one contiguously consistent crystal orientation throughout that grain, one or more grains can also contain small amounts of smaller crystals of silicon of different orientation. For example, each such grain can partially or wholly contain smaller crystals of silicon of other crystal orientations, where such smaller crystals do not make up more than 25% of the overall volume of the grain, preferably not more than 10% of the overall volume of the grain, more preferably not more than 5% of the overall volume of the grain, still more preferably not more than 1% of the overall volume of the grain, and still more preferably not more than 0.1 % of the overall volume of the grain.

In accordance with the invention as embodied and broadly described, there is provided a method of manufacturing cast silicon, comprising: placing molten silicon in contact with a pattern of seed crystals in a vessel having one or more side walls heated to at least the melting temperature of silicon and at least one wall for cooling, wherein the pattern comprises a plurality of single crystal silicon seed crystals, where one or more of the single crystal silicon seed crystals are arranged with a first crystal orientation, and one or more of the single crystal silicon seed crystals are arranged with a second crystal orientation; and forming a solid body comprising a region of monocrystalline silicon, optionally having at least two dimensions each being at least about 10 cm.

In accordance with an embodiment of the present invention, there is also provided a method of manufacturing cast silicon, comprising: placing silicon feedstock in contact with a pattern of silicon seed crystals comprising monocrystalline silicon on at least one surface, wherein the pattern comprises a plurality of single crystal silicon seed crystals, where one or more of the single crystal silicon seed crystals are arranged with a first crystal orientation, and one or more of the single crystal silicon seed crystals are arranged with a second crystal orientation; heating the silicon feedstock and the pattern of silicon seed crystals to the melting temperature of silicon; controlling the heating so that the pattern of silicon seed crystals does not melt completely, the controlling comprising maintaining a ΔT of about 0.1 °C/min or less, as measured on an outside surface of the crucible, after reaching the melting temperature of silicon elsewhere in the crucible; and, once the pattern of silicon seed crystals is partially melted, forming a solid body comprising monocrystalline silicon by cooling the silicon.

In accordance with still a further embodiment of the present invention, there is also provided a body of bi-crystal silicon being free or substantially free of radially-distributed impurities and defects, and having at least two dimensions that are each at least about 25 cm and a third dimension at least about 20 cm.

In accordance with still a further embodiment of the present invention, there is also provided a body of bi-crystal silicon having a carbon concentration of about 2x10¹⁶ atoms/cm³ to about 5x10¹⁷ atoms/cm³, an oxygen concentration not exceeding 5x10¹⁷ atoms/cm³, a nitrogen concentration of at least 1x10¹⁵ atoms/cm³, and having at least two dimensions that are each at least about 25 cm and a third dimension at least about 20 cm.

In accordance with still a further embodiment of the present invention, there is also provided a body of continuous cast bi-crystal silicon having at least two dimensions that are each at least about 35 cm.

In accordance with still a further embodiment of the present invention, there is also provided a solar cell, comprising: a wafer formed from a body of continuous bi-crystal silicon being free or substantially free of radially-distributed impurities and defects, the body having at least two dimensions that are each at least about 25 cm and a third dimension at least about 20 cm; a p-n junction in the wafer; an optional anti-reflective coating on a surface of the wafer; optionally at least one layer selected from a back surface field and a passivating layer; and electrically conductive contacts on the wafer.

In accordance with still a further embodiment of the present invention, there is also provided a solar cell, comprising: a wafer formed from a body of continuous cast bi-crystal silicon, the body having at least two dimensions that are each at least about 35 cm; a p-n junction in the wafer; an optional anti-reflective coating on a surface of the wafer; optionally at least one layer selected from a back surface field and a passivating layer; and electrically conductive contacts on the wafer.

In accordance with still a further embodiment of the present invention, there is also provided a solar cell, comprising: a continuous bi-crystal silicon wafer formed from a body of continuous cast bi-crystal silicon, the wafer having at least one dimension that is at least about 50 mm, and the body having at least two dimensions that are each at least about 25 cm and a third dimension at least about 20 cm; a p-n junction in the wafer; an optional anti-reflective coating on a surface of the wafer; optionally at least one layer selected from a back surface field and a passivating layer; and electrically conductive contacts on the wafer.

In accordance with still a further embodiment of the present invention, there is also provided a wafer, comprising: silicon formed from a body of continuous bi-crystal silicon being free or substantially free of radially-distributed impurities and defects, the body having at least two dimensions that are each at least about 25 cm and a third dimension at least about 20 cm.

In accordance with still a further embodiment of the present invention, there is also provided a wafer, comprising: silicon formed from a body of continuous cast bi-crystal silicon, the wafer having at least one dimension that is at least about 50 mm, and the body having at least two dimensions that are each at least about 25 cm and a third dimension at least about 20 cm.

In accordance with still a further embodiment of the present invention, there is also provided a method of manufacturing cast silicon, comprising: placing molten silicon in contact with at least one silicon seed crystal in a vessel having one or more side walls heated to at least the melting temperature of silicon and at least one wall for cooling; and forming a solid body of bi-crystal silicon, optionally having at least two dimensions each being at least about 10 cm, by cooling the molten silicon to control crystallization, wherein the forming includes forming a solid-liquid interface at an edge of the molten silicon that at least initially parallels the at least one wall for cooling, the interface being controlled during the cooling so as to move in a direction that increases a distance between the molten silicon and the at least one wall for cooling.

In accordance with still a further embodiment of the present invention, there is also provided a method of manufacturing cast silicon, comprising: placing molten silicon in contact with at least one silicon seed crystal in a vessel having one or more side walls heated to at least the melting temperature of silicon, the at least one silicon seed crystal arranged to cover an entire or substantially an entire area of a surface of the vessel; and forming a solid body of bi-crystal silicon, optionally having at least two dimensions each being at least about 10 cm, by cooling the molten silicon to control crystallization.

Additional features and advantages of the invention will be set forth in the description that follows, being apparent from the description or learned by practice of embodiments of the invention. The features and other advantages of the invention will be realized and attained by the semiconductor device structures and methods and apparatuses of manufacture particularly pointed out in the written description and claims, as well as the appended drawings.

In accordance with the present invention, there is also provided a method of manufacturing cast silicon, comprising: coating inner side walls of a crucible with a release coating, leaving a bottom wall uncoated; placing silicon seed crystals in contact with the uncoated wall, placing silicon feedstock in the crucible, melting the feedstock while maintaining the seed crystals in at least a partially solid state, solidifying the silicon by extracting heat through the seed crystals, bringing silicon to a first temperature and cooling the silicon to a second temperature.

In accordance with the present invention, there is also provided a method of manufacturing cast silicon, comprising: slicing a previously cast ingot into slabs, chemically treating the slabs to remove impurities, placing the slab in a crucible for use as a seed layer and then filling the crucible with feedstock for casting.

In accordance with the present invention, there is also provided a method of manufacturing cast silicon, comprising: placing a layer of monocrystalline silicon seed crystals on at least one surface in a crucible such that seed crystals in a center region of the layer have one crystal pole direction perpendicular to the surface and cover about 50% to about 99% of the layer area, while the remaining seed crystals on the edges of the layer have at least one different crystal pole direction perpendicular to the surface and cover the remaining layer area; adding feedstock silicon and bringing the feedstock and a portion of the seed layer to a molten state; solidifying the silicon by extracting heat through the seed layer; bringing the silicon to a predetermined, for example, uniform first temperature and then preferably uniformly cooling the silicon down to a uniform second temperature.

In accordance with the present invention, there is also provided a method of manufacturing cast silicon, comprising: placing at least one monocrystalline seed crystal having at least about 10 cm by about 10 cm area on a bottom surface of a crucible that rests on a partially insulating base plate; introducing solid or liquid silicon feedstock and partially melting the seed crystal, extracting heat through the seed crystal in such a way that a convex solid boundary increases the cross-sectional area of monocrystalline growth; bringing the silicon to a first temperature and cooling it, preferably uniformly, down to a second temperature; cutting a slab from a side of the cast silicon opposite the seed crystal; cleaning the slab using a chemical process; and using the large slab as a new seed layer for a subsequent casting process.

It is to be understood that both the foregoing general description and the following detailed description are exemplary and explanatory, and are intended to provide further explanation of the invention as claimed. This invention also includes silicon made by the methods described and claimed herein, and wafers and solar cells made from such silicon.

### BRIEF DESCRIPTION OF THE DRAWINGS

The accompanying drawings, which are incorporated in and constitute a part of this specification, illustrate embodiments of the invention and, together with the description, serve to explain the features, advantages, and principles of the invention. In the drawings:

FIG. 1 illustrates an exemplary arrangement of silicon seeds on the bottom surface of a crucible, according to an embodiment of the present invention;

FIG. 2 illustrates an exemplary arrangement of silicon seeds on the bottom surface of a crucible, according to an embodiment of the present invention;

FIG. 3 illustrates a cross-section of a cast ingot using seed crystals having a single crystal orientation;

FIG. 4 illustrates a cross-section of a cast ingot using seed crystals, of which some seed crystals have one crystal orientation and some seed crystals have another crystal orientation, according to an embodiment of the present invention;

FIG. 5 illustrates an exemplary method, according to an embodiment of the present invention;

FIGS. 6A-6G and 7 illustrate exemplary casting processes for monocrystalline or bi-crystal silicon, according to embodiments of the present invention;

FIG. 8 illustrates an example of silicon feedstock loaded into a partially coated crucible, according to an embodiment of the present invention;

FIG. 9 illustrates an example of a method for recycling seed layer material, according to an embodiment of the present invention;

FIG. 10 illustrates an exemplary arrangement of single crystal silicon to form a seed layer, according to an embodiment of the present invention; and

FIG. 11 illustrates an exemplary method for creating large single crystal seed layers, according to an embodiment of the present invention.

### DESCRIPTION OF THE EMBODIMENTS

Reference will now be made in detail to embodiments of the present invention, examples of which are illustrated in the accompanying drawings. Wherever possible, the same or similar reference numbers will be used throughout the drawings to refer to the same or like parts.

In embodiments consistent with the invention, the crystallization of molten silicon is conducted by casting processes using one or more seed crystals. As disclosed herein, such casting processes may be implemented so that the size, shape, and orientation of crystal grains in the cast body of crystallized silicon is controlled. As used herein, the term "cast" means that the silicon is formed by cooling molten silicon in a mold or vessel used to hold the molten silicon. Since a liquid, such as molten silicon, will take the shape of the container in which it is placed, it is also contemplated herein that the cooling of molten silicon may also be accomplished while confining the molten silicon by any means, and not just in a mold or vessel. By way of example, the silicon can be formed by solidification in a crucible, where solidification is initiated from at least one wall of the crucible, and not through a cooled foreign object introduced into the melt. The crucible may have any suitable shape, such as a cup, a cylinder, or a box. Thus, the process of molten silicon crystallization according to this invention is not controlled by "pulling" a boule or ribbon. Further, consistent with an embodiment of the present invention, the mold, vessel, or crucible includes at least one "hot side wall" surface in contact with the molten silicon. As used herein, the term "hot side wall" refers to a surface that is isothermal with or hotter than the molten silicon that it contacts. Preferably, a hot side wall surface remains fixed during processing of the silicon.

Consistent with embodiments of the invention, the crystallized silicon can be either continuous monocrystalline, near-monocrystalline silicon, continuous bi-crystal, or continuous geometric multi-crystalline having controlled grain orientations. As used herein, the term "continuous monocrystalline silicon" refers to single crystal silicon, where the body of silicon is one homogeneous body of monocrystalline silicon and not smaller pieces of silicon joined together to form a larger piece of silicon. Further, as used herein, the term "continuous geometric multi-crystalline silicon" refers to geometric multi-crystalline silicon where the body of silicon is one homogeneous body of geometric multi-crystalline silicon and not smaller pieces of silicon joined together to form a larger piece of silicon. Further, as used herein, the term "continuous bi-crystal" refers to a homogenous body of bi-crystal silicon having only two crystal orientations throughout and not separate pieces of monocrystalline silicon joined together to form a bi-crystal.

Consistent with embodiments of the present invention, the crystallization can be accomplished by positioning a desired collection of crystalline silicon "seeds" in, for example, the bottom of a vessel, such as a quartz crucible that can hold molten silicon. As used herein, the term "seed" refers to a preferably geometrically shaped piece of silicon with a desired crystal structure, preferably wherein at least one cross-section has a geometric, preferably polygonal, shape, and preferably having a side that conforms to a surface of a vessel in which it may be placed. Such a seed can be either a monocrystalline piece of silicon or a piece of geometrically ordered multi-crystalline silicon, for example, a slab or horizontal section cut or otherwise obtained from an ingot of monocrystalline silicon. Consistent with the present invention, a seed may have a top surface that is parallel to its bottom surface, although this does not have to be the case. For example, a seed can be a piece of silicon, varying in size from about 2 mm to about 3000 mm across. For example, a seed can be about 10 mm to about 300 mm across. The piece of silicon may have a thickness of about 1 mm to about 1000 mm, preferably about 5 mm to about 50 mm. A suitable size and shape of the seed may be selected for convenience and tiling. Tiling, which will be described in more detail below, is where silicon seed crystals are arranged in a predetermined geometric orientation or pattern across, for example, the bottom or one or more of the sides and the bottom surfaces of a crucible. It is preferable that the seed or seeds cover the entire crucible surface next to which they are located, so that when moving the seeded crystal growth solidification front away from the seeds, the full size of the crucible cross-section can be maintained as a consistent geometric crystal.

The molten silicon is then allowed to cool and crystallize in the presence of the seeds, preferably in a manner such that the cooling of the molten silicon is conducted so that the crystallization of the molten silicon starts at or below the level of the original top of the solid seeds and proceeds away, preferably upwards away, from the seeds. The solid-liquid interface at an edge of the molten silicon will preferably initially conform to a cooling surface of the vessel, such as a surface in a crucible, in which it is being cast. According to embodiments of the invention, the liquid-solid interface between the molten silicon and the crystallized silicon can be maintained substantially flat throughout part, for example, the initial part of the solidification stage, or all of the casting process. In an embodiment of the invention, the solid-liquid interface at each of the edges of the molten silicon is controlled during the cooling so as to move in a direction that increases a distance between the molten silicon and the cooled surface of the crucible while preferably maintaining a substantially flat solid-liquid interface.

Therefore, consistent with the present invention, the solidification front may parallel the shape of a cooled surface of the vessel. For example, with a flat-bottomed crucible, the solidification front may remain substantially flat, with the solid-liquid interface having a controlled profile. The solid-liquid interface can be controlled so that its radius of curvature decreases as one moves from the edge to the center. Alternatively, the solid-liquid interface can be controlled to maintain an average radius of curvature of at least half the width of the vessel. Moreover, the solid-liquid interface can be controlled to maintain an average radius of curvature of at least twice the width of the vessel. The solid can have a slightly convex interface with a radius of curvature at least about four times the width of the vessel. For example, the solid-liquid interface can have a radius of curvature generally greater than 2 m in a 0.7 m square crucible, more than twice the horizontal dimension of the crucible, and preferably about 8x to about 16x a horizontal dimension of the crucible.

According to embodiments of the present invention, a solid body of monocrystalline silicon, bi-crystal silicon, or near-monocrystalline silicon, preferably cast, preferably having at least two dimensions each being at least about 20 cm, for example, at least about 20 cm on a side, and a third dimension at least about 10 cm, can be formed. Preferably, a solid body of monocrystalline silicon, bi-crystal silicon, or near-monocrystalline silicon, preferably cast, having at least two dimensions each being at least about 30 cm, for example, at least about 30 cm on a side, and a third dimension at least about 10 cm, can be formed. More preferably, a solid body of monocrystalline silicon, bi-crystal silicon, or near-monocrystalline silicon, preferably cast, having at least two dimensions each being at least about 35 cm, for example, at least about 35 cm on a side, and a third dimension at least about 10 cm, can be formed. Still more preferably, a solid body of monocrystalline silicon, bi-crystal silicon, or near-monocrystalline silicon, preferably cast, having at least two dimensions each being at least about 40 cm, for example, at least about 40 cm on a side, and a third dimension at least about 20 cm, can be formed. Still more preferably, a solid body of monocrystalline silicon, bi-crystal silicon, or near-monocrystalline silicon, preferably cast, having at least two dimensions each being at least about 50 cm, for example, at least about 50 cm on a side, and a third dimension at least about 20 cm, can be formed. Still more preferably, a solid body of monocrystalline silicon, bi-crystal silicon, or near-monocrystalline silicon, preferably cast, having at least two dimensions each being at least about 60 cm, for example, at least about 60 cm on a side, and a third dimension at least about 20 cm, can be formed. Still more preferably, a solid body of monocrystalline silicon, bi-crystal silicon, or near-monocrystalline silicon, preferably cast, having at least two dimensions each being at least about 70 cm, for example, at least about 70 cm on a side, and a third dimension at least about 20 cm, can be formed. According to embodiments of the present invention, a body of continuous monocrystalline silicon, continuous bi-crystal silicon, or near-monocrystalline silicon, being free, or substantially free, of radially-distributed defects and/or impurities, preferably having at least two dimensions each being at least about 20 cm, and a third dimension at least about 10 cm, can be formed. Preferably, a body of continuous monocrystalline silicon, continuous bi-crystal silicon, or near-monocrystalline silicon, being free, or substantially free, of radially-distributed defects and/or impurities, having at least two dimensions each being at least about 30 cm, and a third dimension at least about 10 cm, can be formed. More preferably, a body of continuous monocrystalline silicon, continuous bi-crystal silicon, or near-monocrystalline silicon, being free, or substantially free, of radially-distributed defects and/or impurities, having at least two dimensions each being at least about 35 cm, and a third dimension at least about 10 cm, can be formed. Still more preferably, a body of continuous monocrystalline silicon, continuous bi-crystal silicon, or near-monocrystalline silicon, being free, or substantially free, of radially-distributed defects and/or impurities, having at least two dimensions each being at least about 40 cm, and a third dimension at least about 20 cm, can be formed. Still more preferably, a body of continuous monocrystalline silicon, continuous bi-crystal silicon, or near-monocrystalline silicon, being free, or substantially free, of radially-distributed defects and/or impurities, having at least two dimensions each being at least about 50 cm, and a third dimension at least about 20 cm, can be formed. Still more preferably, a body of continuous monocrystalline silicon, continuous bi-crystal silicon, or near-monocrystalline silicon, being free, or substantially free, of radially-distributed defects and/or impurities, having at least two dimensions each being at least about 60 cm, and a third dimension at least about 20 cm, can be formed. Still more preferably, a body of continuous monocrystalline silicon, continuous bi-crystal silicon, or near-monocrystalline silicon, being free, or substantially free, of radially-distributed defects and/or impurities, having at least two dimensions each being at least about 70 cm, and a third dimension at least about 20 cm, can be formed.

An upper limit of horizontal size of an ingot of cast silicon made according to embodiments of the invention is only determined by casting and crucible making technology, and not by the invented method itself. Ingots having a cross-sectional area of at least 1 m² and up to 4-8 m² can be manufactured according to this invention. Similarly, an upper limit of the height of the ingot may be related to longer cycle times, and not the fundamentals of the casting process. Ingot heights of up to about 50 cm to about 80 cm are possible. Thus, consistent with the invention, a body of continuous monocrystalline silicon, continuous bi-crystal silicon, or near-monocrystalline silicon, can be successfully grown to about 66 cm x 66 cm in cross section, with a rectangular solid piece of continuous monocrystalline silicon being at least 33,750 cm³ in volume. Further, consistent with the present invention, a solid body of cast continuous monocrystalline silicon, continuous bi-crystal silicon, or near-monocrystalline silicon, can be formed preferably having at least two dimensions each being as large as the interior dimensions of a casting vessel and the third dimension being the same height as the ingot. For example, if the cast body of silicon is a cube-shaped or a rectangular-shaped solid, these dimensions above would refer to the length, width, and height of such bodies.

By conducting the crystallization of the molten silicon in a manner consistent with embodiments of the invention, cast silicon having specific, rather than random, grain boundaries and specific grain sizes can be made. Additionally, by aligning the seed(s) in a manner such that all seeds are oriented the same relative direction to each other, for example the (100) pole direction being perpendicular to a bottom of the crucible and the (110) pole direction parallel to one of the sides of a rectangular or square cross-section crucible, large bodies of cast silicon can be obtained that are, or are nearly, monocrystalline silicon in which the pole direction of such cast silicon is the same as that of the seed(s). Similarly, other pole directions may be perpendicular to the bottom of the crucible. In addition, an arrangement of seeds may have more than one pole direction perpendicular to the bottom of the crucible. For example, an arrangement may include a center portion of seeds having one pole direction perpendicular to the bottom of the crucible, and another "protective" portion of seeds surrounding the center portion and having another pole direction perpendicular to the bottom of the crucible. Moreover, consistent with an embodiment of the invention, the seed(s) may be arranged so that any one common pole direction, or any two common pole directions, is/are perpendicular to a bottom of the crucible.

When monocrystalline silicon is made by the conventional method of pulling a cylindrically shaped boule from a pool of molten silicon, e.g., according to the CZ or FZ methods, the monocrystalline silicon obtained contains radially distributed impurities and defects, such as swirl defects (formed from intrinsic defects such as vacancies and self-interstitial atoms) and OSF ring defects. Swirl defects are interstitial silicon atoms or vacancies, either in singular or clustered form. Such swirl defects can be detected by x-ray topography and appear as "swirls" in the silicon. They can also be detected after preferential acid etching of the silicon for defect delineation.

According to the conventional CZ or FZ methods, the distribution of oxygen atoms within the silicon and the defects in the silicon caused by such oxygen atoms are radially situated. This means that they tend to be arranged in rings, spirals or striations that are symmetric about a central axis. OSF ring defects are a particular example of this, where nanometer-scale oxygen precipitates nucleate stacking faults in a cylindrical band within a pulled monocrystalline ingot or boule of silicon, resulting in circular defect bands on wafers made from such silicon. Such bands can be observed in a sample of silicon after preferential acid etching.

Both swirl defects and OSF ring defects occur in the boules of monocrystalline silicon by pulling a cylindrically shaped boule from a pool of molten silicon, e.g., according to the conventional CZ or FZ methods, due to the rotational symmetry of the pulling process, the axial thermal gradients, and the rotation inherent in the process. In contrast, silicon can be made by casting processes according to embodiments of the invention that does not exhibit such swirl defects and OSF ring defects. This is because the incorporation of defects during the casting process can be essentially distributed randomly at a growth interface not influenced by rotation, in a body of silicon that does not possess cylindrical symmetry, and in a process where the isotherms are essentially flat across the ingot throughout the solidification and the cool-down processes.

Concerning the concentrations of light element impurities in silicon grown by different methods, the following levels, shown in TABLE 1, are widely considered characteristic.

**TABLE 1**

| | **Concentrations (atoms/cm³)** | | |
|---|---|---|---|
| | **Oxygen** | **Carbon** | **Nitrogen** |
| **Float Zone** | < 1x10¹⁶ | < 1x10¹⁶ | < 1x10¹⁴ |
| **Czochralski** | 2x10¹⁷ - 1x10¹⁸ | < 1x10¹⁶ | < 5x10¹⁴ |
| **Cast** | 2-3x10¹⁷ | 2x10¹⁶ - 5x10¹⁷ | > 1x10¹⁵ |

Parts of CZ ingots can be produced with as low as 5x10¹⁷ atoms/cm³ of oxygen, but not lower. Carbon and nitrogen concentrations can be increased in FZ and CZ ingots by intentional doping, but doping does not exceed the solid solubility limit in these techniques (as it does in cast material), and doped ingots have not been made in sizes larger than 20 cm diameter. By contrast, cast ingots are typically supersaturated with carbon and nitrogen due to release coatings and the design of the furnace hot zone. As a consequence, precipitated nitrides and carbides are ubiquitous due to liquid phase nucleation and growth. Furthermore, cast single crystal ingots have been manufactured, according to embodiments of the invention, with the above-reported impurity levels and with sizes as large as 50x50x20 cm³ and 60x60x5 cm³. These dimensions are exemplary only, and are not considered upper limits for the casting processes of the invention.

For example, regarding impurity levels, a dissolved carbon concentration of about 1-5x10¹⁷ atoms/cm³ (notation for about 1x10¹⁷ atoms/cm³ to about 5x10¹⁷ atoms/cm³), a dissolved oxygen concentration of about 2-3x10¹⁷ atoms/cm³, and a dissolved nitrogen concentration of about 1-5x10¹⁵ atoms/cm³ are preferred in the silicon cast according to this invention. According to embodiments of the present invention, a solid body of monocrystalline silicon, bi-crystal silicon, or near-monocrystalline silicon, preferably cast, preferably having at least two dimensions each being at least about 20 cm, for example, at least about 20 cm on a side, and a third dimension at least about 10 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Preferably, a solid body of monocrystalline silicon, bi-crystal silicon, or near-monocrystalline silicon, preferably cast, having at least two dimensions each being at least about 30 cm, for example, at least about 30 cm on a side, and a third dimension at least about 10 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. More preferably, a solid body of monocrystalline silicon, bi-crystal silicon, or near-monocrystalline silicon, preferably cast, having at least two dimensions each being at least about 35 cm, for example, at least about 35 cm on a side, and a third dimension at least about 10 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a solid body of monocrystalline silicon, bi-crystal silicon, or near-monocrystalline silicon, preferably cast, having at least two dimensions each being at least about 40 cm, for example, at least about 40 cm on a side, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a solid body of monocrystalline silicon, bi-crystal silicon, or near-monocrystalline silicon, preferably cast, having at least two dimensions each being at least about 50 cm, for example, at least about 50 cm on a side, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a solid body of monocrystalline silicon, bi-crystal silicon, or near-monocrystalline silicon, preferably cast, having at least two dimensions each being at least about 60 cm, for example, at least about 60 cm on a side, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a solid body of monocrystalline silicon, bi-crystal silicon, or near-monocrystalline silicon, preferably cast, having at least two dimensions each being at least about 70 cm, for example, at least about 70 cm on a side, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³.

According to embodiments of the present invention, a body of continuous monocrystalline silicon, continuous bi-crystal silicon, or near-monocrystalline silicon, being free, or substantially free, of radially-distributed defects and/or impurities, preferably having at least two dimensions each being at least about 20 cm, and a third dimension at least about 10 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Preferably, a body of continuous monocrystalline silicon, continuous bi-crystal silicon, or near-monocrystalline silicon, being free, or substantially free, of radially-distributed defects and/or impurities, having at least two dimensions each being at least about 30 cm, and a third dimension at least about 10 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. More preferably, a body of continuous monocrystalline silicon, continuous bi-crystal silicon, or near-monocrystalline silicon, being free, or substantially free, of radially-distributed defects and/or impurities, having at least two dimensions each being at least about 35 cm, and a third dimension at least about 10 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a body of continuous monocrystalline silicon, continuous bi-crystal silicon, or near-monocrystalline silicon, being free, or substantially free, of radially-distributed defects and/or impurities, having at least two dimensions each being at least about 40 cm, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a body of continuous monocrystalline silicon, continuous bi-crystal silicon, or near-monocrystalline silicon, being free, or substantially free, of radially-distributed defects and/or impurities, having at least two dimensions each being at least about 50 cm, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a body of continuous monocrystalline silicon, continuous bi-crystal silicon, or near-monocrystalline silicon, being free, or substantially free, of radially-distributed defects and/or impurities, having at least two dimensions each being at least about 60 cm, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³. Still more preferably, a body of continuous monocrystalline silicon, continuous bi-crystal silicon, or near-monocrystalline silicon, being free, or substantially free, of radially-distributed defects and/or impurities, having at least two dimensions each being at least about 70 cm, and a third dimension at least about 20 cm, can be formed, having a dissolved carbon concentration of about 1-5x10¹⁷ atoms/cm³, a dissolved oxygen concentration of about 2-3x10¹⁷ atoms/cm³, and a dissolved nitrogen concentration of about 1-5x10¹⁵ atoms/cm³.

An upper limit of horizontal size of an ingot of cast silicon made according to embodiments of the invention, and having the above-referenced impurity concentrations, is only determined by casting and crucible making technology, and not by the invented method itself. Thus, consistent with the present invention, a solid body of cast continuous monocrystalline silicon, continuous bi-crystal silicon, or near-monocrystalline silicon, having the above-referenced impurity concentrations, can be formed preferably having at least two dimensions each being as large as the interior dimensions of a casting vessel and the third dimension being the same height as the ingot. For example, if the cast body of silicon is a cube-shaped or a rectangular-shaped solid, these dimensions above would refer to the length, width, and height of such bodies.

The seed(s) used for casting processes, consistent with embodiments of the invention, can be of any desired size and shape, but are suitably geometrically shaped pieces of monocrystalline silicon, bi-crystal silicon, near-monocrystalline silicon, or geometrically ordered multi-crystalline silicon, such as square, rectangular, hexagonal, rhomboid or octagonal shaped pieces of silicon. They can be shaped conducive to tiling, so they can be placed or "tiled" edge-to-edge and conformed to the bottom of a crucible in a desired pattern. Also consistent with embodiments of the invention, seeds can be placed on one or more, including all, sides of the crucible. Such seeds can be obtained, for example, by sawing a source of crystalline silicon, such as a boule of monocrystalline silicon, into pieces having the desired shapes. The seeds can also be formed by cutting them from a sample of either continuous monocrystalline, continuous bi-crystal silicon, near-monocrystalline silicon, or continuous geometric multi-crystalline silicon made by a process according to embodiments of the invention, such that seed(s) for use in subsequent casting processes can be made from an initial casting process. Thus, for example, a slab of either continuous monocrystalline, continuous bi-crystal silicon, or near-monocrystalline silicon cut or otherwise obtained from an ingot of continuous monocrystalline, continuous bi-crystal silicon, or near-monocrystalline silicon can function as a template for a subsequent casting. Such a seed crystal or crystals can be the size and shape, or substantially the size and shape, of a side, such as the bottom, of a crucible or other vessel in which the seed is placed. For the purposes of monocrystalline casting, it is preferable to have as few seeds as possible to cover the crucible bottom in order to avoid the incorporation of defects. For the purposes of monocrystalline casting, it is also preferable to have a predetermined arrangement of seeds having two different crystal orientations, such as (100) and (111), covering the crucible bottom. Preferably, an arrangement of seed crystals may include a center portion of seeds having a (100) pole direction perpendicular to the bottom of the crucible, and another "protective" portion of seeds having a (111) pole direction perpendicular to the bottom of the crucible and surrounding the center portion. Thus, the seed or seeds can be the size and shape, or substantially the size and shape, of one or more sides, such as the bottom, of a crucible or other vessel in which the seed or seeds is placed to perform the casting method in accordance with this invention.

Processes and apparatuses for preparing silicon in accordance with certain embodiments of the invention will now be described. However, it is to be understood that these are not the only ways to form silicon consistent with the principles of the invention.

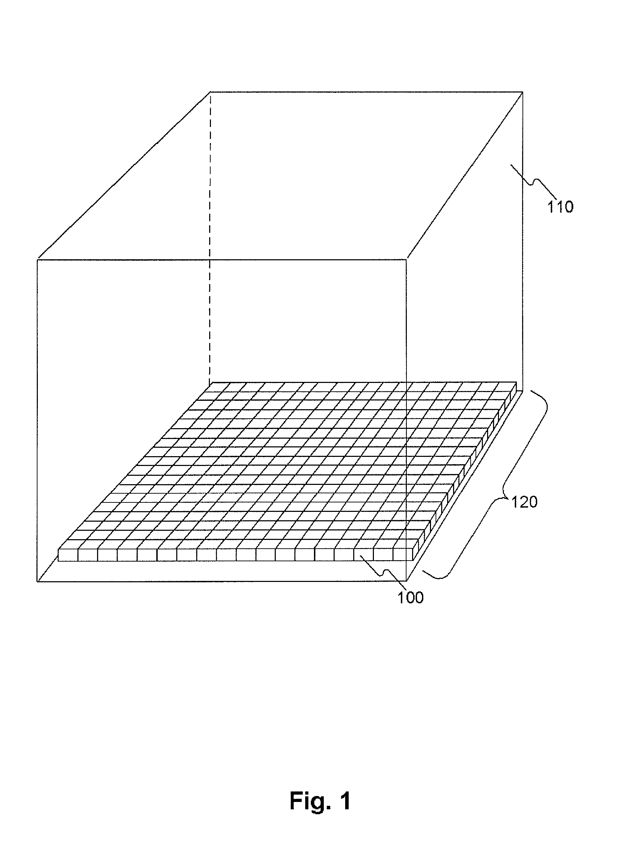

Referring to FIG. 1, seeds 100 are placed at the bottom of a bottomed and walled crucible 110, such as a quartz crucible, in a way such that either they closely abut in the same orientation so as to form a large, continuously oriented slab 120. Alternatively, they closely abut in pre-selected misorientations so as to produce specific grain boundaries with deliberately chosen grain sizes in the resulting silicon that is produced.

For example, for casting of geometric multi-crystalline silicon, the cross-sectional grain size and, preferably, cross-sectional shape of the resulting crystallized geometric multi-crystalline silicon will be equal to or will approximate that of the seeds and the height of the grain can be a long as the dimension of the silicon that is perpendicular to the cross-section. If a geometric multi-crystalline seed crystal, for example, a slab of geometric multi-crystalline silicon cut or otherwise obtained from an ingot of geometric multi-crystalline silicon, is used a seed crystal or seed crystals for casting geometric multi-crystalline silicon, the cross-sectional grain size and, preferably, cross-sectional shape of the grains of the resulting geometric multi-crystalline silicon will approximate the grains in the geometric multi-crystalline seed or seeds. Thus, a slab of geometric multi-crystalline silicon cut or otherwise obtained from an ingot of geometric multi-crystalline silicon can be a "geometric multi-crystalline silicon seed crystal" (also referred to as a "geometrically ordered multi-crystalline silicon seed crystal"), and can function as a template for a subsequent casting of geometric multi-crystalline silicon. Such a seed crystal can be the size and shape, or substantially the size and shape, of a side, such as the bottom, of a crucible or other vessel in which the seed is placed. When such a seed crystal is used in the method of this invention, the resulting geometric multi-crystalline silicon will preferably have crystal grains that have the same or substantially the same cross-sectional size and shape as the grains in the seed.

Seeds 100 may be tiled and are preferably placed so as to substantially cover the entirety of the bottom of crucible 110. It is also preferable that crucible 110 has a release coating such as one made from silica, silicon nitride, or a liquid encapsulant, to aid in the removal of crystallized silicon from crucible 110. Further, the seeds may comprise a slab or slabs of monocrystalline silicon of a desired crystal orientation, or two different desired crystal orientations, about 3 mm to about 100 mm thick. While a specific number and size of seeds 100 is shown in FIG. 1, it will be readily apparent to one of ordinary skill in the art that both the number and size of the seeds can be increased or decreased, depending on the application.

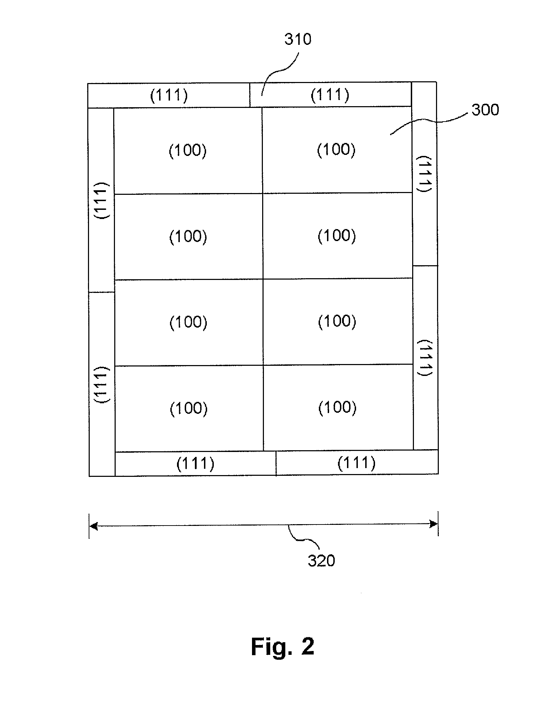

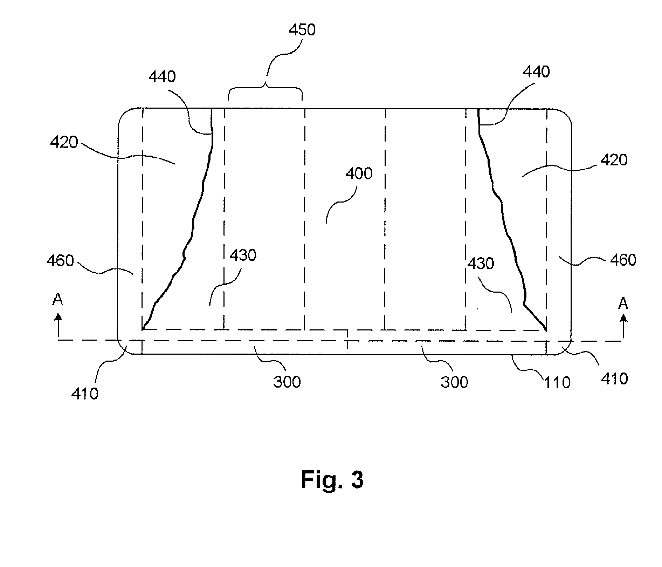

Referring to FIG. 2, a plan view of an alternative arrangement of seeds 300 and 310 is presented. In FIG. 2, seeds 300 and 310 are placed at the bottom of a bottomed and walled crucible (not shown), such as crucible 110 shown in FIG. 1, in a way such that they closely abut in two different crystal orientations so as to cover, or nearly completely cover, a full width 320 of a bottom surface of a bottomed and walled crucible. Consistent with the present invention, the seeds 300 and 310 may be single crystal silicon pieces. Preferably, seeds 300 may have a (100) crystal orientation, while seeds 310 may have a (111) crystal orientation, such that their respective pole directions are perpendicular to the bottom surface of crucible 110. As shown in FIG. 2, a series of (111) seeds 310 are selectively placed so as to surround a series of (100) seeds 300. While seeds 310 are shown in FIG. 2, having a (111) pole direction perpendicular to the bottom surface of crucible 110, because it is believed that the (111) crystal orientation provides for a low-energy growth front, other crystal orientations may be possible for seeds 310. Preferably, seeds 300 will have a different crystal orientation than seeds 310. While a specific number and size of seeds 300 and 310 is shown in FIG. 2, it will be readily apparent to one of ordinary skill in the art that the number, size, and crystal orientation of the seeds can be changed, depending on the application. For example, one of the two series of seed crystals 300 and 310 could be a single slab of monocrystalline silicon. That is, seeds 300 could be a single slab of monocrystalline (100) silicon, surrounded by a series of (111) seeds 310, or any alternative combination thereof, to cover the bottom surface of crucible 110. When making silicon that has such a specifically selected arrangement of seeds, and, consequently, grain boundaries, preferably the grain boundary junctions only have three grain boundaries meeting at a given corner, which is shown in the seed crystal arrangement of Fig. 2. Thus, seeds 300 can be placed on a bottom surface of the crucible, and seeds 310 can be placed on the periphery area of the bottom of the crucible not occupied by seeds 300. Ingots produced by silicon casting with respect to the use of seeds 300 and 310 will be described later with reference to FIGS. 3, 4, and 6G.

Consistent with the seed layouts (or patterns) disclosed in FIGS. 1-2, for example, silicon feedstock (not shown) may then be introduced into crucible 110 over seeds 100, 300, and/or 310, and then melted. Alternatively, molten silicon may be poured into crucible 110. In the alternative example, crucible 110 may be first brought very close to, or up to, the melting temperature of silicon, and then the molten silicon is poured in. Consistent with embodiments of the invention, a thin layer of the seeds can be melted before solidification begins.

Then, in any of the examples discussed above, crucible 110 is cooled, whereby heat is removed from the bottom of crucible 110 (and sides only if seeds are tiled on the side surfaces as well) by, for example, a solid heat sink material which radiates heat to the ambient, while heat is still applied to the open top of crucible 110. Thus, melted silicon is introduced while the seed is maintained as a solid, and directional solidification of the melt causes the upwards growth of the columnar grains. In this way, the resulting cast ingot of silicon will mimic the crystal orientations of the silicon seeds 100 or 300 and 310. The resulting ingot can be cut into, for example, horizontal slabs to act as seed layers for other casting processes. The slab can have, for example, the size and shape, or substantially the size and shape, of a surface, such as a bottom, of a crucible or other vessel used for the casting. For example, only one such slab can be used for a casting process. Thus, the orientation of seed crystals in a crucible used to form the silicon may be chosen to specifically affect and ultimately control the resulting crystal structure of the cast ingot of silicon.

In contrast to embodiments of the invention, known casting processes involve the casting of multi-crystalline grains in an uncontrolled fashion by directional solidification from a completely melted mass of silicon. The resulting grains have basically random orientation and size distribution. The random grain orientation makes it difficult to effectively texture the silicon surface. Furthermore, it has been shown that kinks in the grain boundaries, natural products of the typical growth techniques, tend to nucleate structural defects involving clusters or lines of dislocations. These dislocations, and the impurities that they tend to attract, cause fast recombination of electrical carriers and the degradation of performance as a photovoltaic material. Therefore, consistent with an embodiment of the invention, careful planning and seeding of a regular grain boundary network for casting of either monocrystalline or bi-crystal silicon is accomplished such that the size, shape and orientation of grains is explicitly chosen to maximize minority carrier lifetime and impurity gettering while minimizing structural defects.

In an alternative to the placing of individual seeds 100, or 300 and 310, instead of using a plurality of monocrystalline seed crystals, a section or slab of silicon cut or otherwise obtained from an ingot produced in a prior casting of monocrystalline silicon, bi-crystal silicon, or near-monocrystalline silicon can be used as a single seed crystal for casting monocrystalline silicon, bi-crystal silicon, or near-monocrystalline silicon in accordance with this invention. Such a single seed crystal can be the same size and shape, or substantially the same size and shape, as a surface of the crucible or other vessel used to conduct the casting. For example, a single seed crystal taken from a cast ingot of silicon formed using the seed layout or pattern shown in FIG. 2 can be used for a subsequent casting process. Any of the seed arrangements discussed above are also applicable to an embodiment for casting either a solid body of monocrystalline silicon, a solid body of bi-crystal silicon, or a solid body of near-monocrystalline silicon, where the seed crystals are so placed on the bottom, or both the bottom and side surfaces of a crucible.

Referring to FIG. 3, a vertical cross section is shown through the middle of crucible 110 after solidification of an ingot of cast silicon 400. A plan view of the line A-A in FIG. 3 corresponds to the seed layout or pattern illustrated in FIG. 2. In the example illustrated in FIG. 3, (100) seeds 300 are placed on the bottom surface of crucible 110, as shown in the plan view of FIG. 2, with the exception that (111) seeds are not placed surrounding (100) seeds 300. In this example, the resulting ingot of silicon 400 is in contact with surfaces of the crucible that can serve as a multitude of nucleation sites for crystal growth of different grain orientations during the solidification phase of a casting process. A curved corner 410 of crucible 110, for example, may serve as a nucleation site for growth of a multicrystalline silicon region 420, the growth of which will compete with nucleation and growth of a (100) monocrystalline silicon region 430 from (100) seeds 300. During casting, multicrystalline silicon region 420 encroaches over the seeds 300, such that the resulting ingot 400 is part monocrystalline silicon and part multicrystalline silicon. The divisions between (100) monocrystalline silicon region 430 and multicrystalline silicon region 420 are illustrated by lines 440, which depict how multicrystalline silicon region 420 grows outward from its nucleation site at the corner 410. Thus, nucleation and growth of (100) monocrystalline silicon region 430 is eroded due to competitive lateral grain growth of randomly-oriented grains, for example, from the sidewalls of crucible 110.

Still referring to FIG. 3, after casting is completed, the resulting ingot of cast silicon 400 is cut into five rows of bricks 450 and two side plates 460. Side plates 460 are typically multicrystalline silicon and may contain impurities from the walls of crucible 110 diffused during casting. Side plates 460 are thus removed and may be used as feedstock for subsequent casting processes. If casting of (100) monocrystalline silicon is desired, only three of the five bricks 450 shown in FIG. 3 will contain (100) monocrystalline silicon. Two bricks 450 and both side plates 460 will contain multicrystalline silicon only, or a combination of multicrystalline silicon and monocrystalline silicon, as indicated by the bricks 450 through which lines 440 traverse. Thus, the volume yield of (100) monocrystalline silicon region 430 in ingot 400 will be reduced by the volume of multicrystalline silicon region 420.

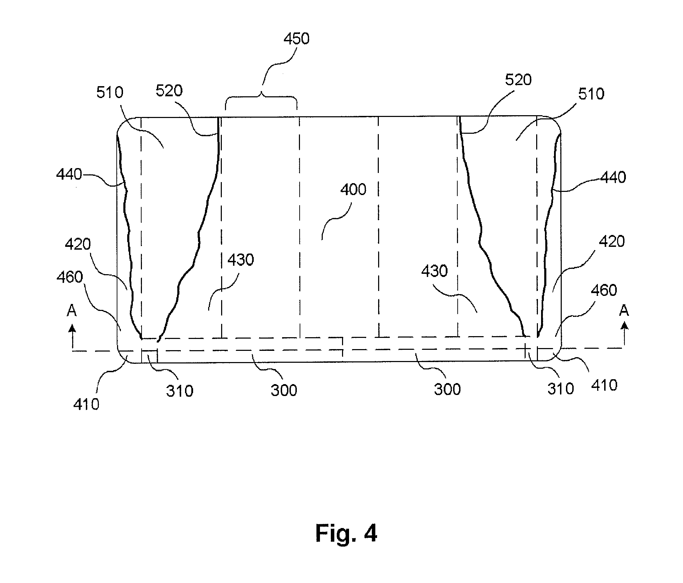

Referring to FIG. 4, a vertical cross section is shown through the middle of crucible 110 after solidification of an ingot of cast silicon 400. A plan view of the line A-A in FIG. 4 similarly corresponds to the seed layout or pattern illustrated in FIG. 2. In the example illustrated in FIG. 4, the arrangement of seeds 300 and 310 shown in FIG. 2 has been used, with (100) seeds 300 placed on the bottom surface of crucible 110, and (111) seeds 310 placed surrounding (100) seeds 300. In this example, a portion of the resulting ingot of silicon 400 is in contact with surfaces of the crucible, including the curved corner 410 of crucible 110, which may serve as a nucleation site for growth of a multicrystalline silicon region 420. Nucleation and growth of (111) monocrystalline silicon region 510, however, will compete with and ultimately limit the amount of growth of multicrystalline silicon region 420.

Thus, during casting, growth of multicrystalline silicon region 420 is limited by competing growth of (111) monocrystalline silicon region 510 over (111) seeds 310. The divisions between (111) monocrystalline silicon region 510 and multicrystalline silicon region 420 are illustrated by lines 440, which depict how multicrystalline silicon region 420 growth is limited by the outward growth of (111) monocrystalline silicon region 510 from its nucleation sites at seeds 310. Similarly, the divisions between (111) monocrystalline silicon region 510 and (100) monocrystalline silicon region 430 are illustrated by lines 520, which depict the intersection of the grains of (111) monocrystalline silicon region 510 grown from (111) seeds 310, and (100) monocrystalline silicon region 430 grown from (100) seeds 300. The resulting ingot 400 thus only contains multicrystalline silicon region 420 in side plates 460. A high-quality bi-crystal of (100) and (111) monocrystalline silicon is thus contained in the regions 430 and 510 of the ingot of cast silicon 400. The nucleation and growth of (111) monocrystalline silicon region 510 restricts competitive lateral grain growth of randomly-oriented grains from the sidewalls of crucible 110.

Still referring to FIG. 4, after casting is completed, the resulting ingot of cast silicon 400 is cut into five rows of bricks 450 and two side plates 460. Side plates 460, containing multicrystalline silicon region 420 are removed and may be used as feedstock for subsequent casting processes. Thus, all of the five bricks 450 shown in FIG. 4 will contain monocrystalline silicon or bi-crystal silicon, with the central three bricks 450 containing (100) monocrystalline silicon and the two outer bricks containing a high quality bi-crystal of part (100) and part (111) orientation silicon. The amount of multicrystalline silicon is therefore reduced by growing a (111) monocrystalline silicon region 510, which limits the volume of multicrystalline silicon region 420. Thus, in the example shown in FIG. 4, casting silicon from a seed layout or pattern shown in FIG. 2 provides a buffer against the growth of multicrystalline silicon and improves the amount of monocrystalline silicon regions per cast ingot of silicon. This is believed to be due to the low-energy growth front of the (111) crystal orientation in (111) seeds 310, which will nucleate and grow more rapidly than the nucleation and growth of randomly oriented multicrystalline silicon at the corners 410 of crucible 110.

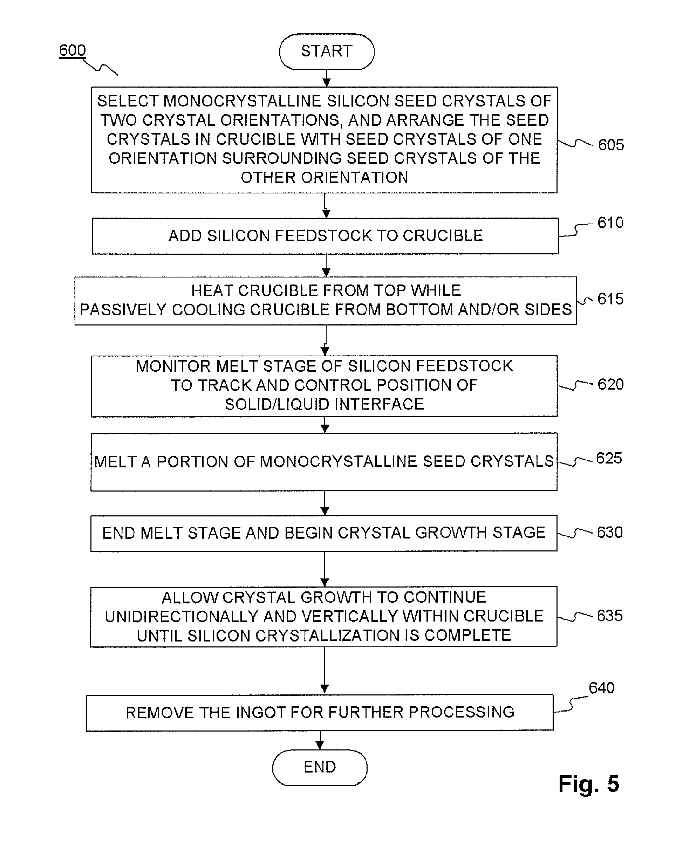

FIG. 5 is a flowchart depicting an exemplary method of making silicon, consistent with the present invention. Consistent with FIG. 5, method 600 may begin by selecting monocrystalline silicon seed crystals of two crystal orientations, such as (100) and (110), for monocrystalline silicon growth, and arranging the monocrystalline silicon seed crystals in a crucible such that the seed crystals of one crystal orientation are placed such that they surround the seed crystals having the other crystal orientation (step 605). Alternatively, a single slab cut or otherwise obtained from an ingot of monocrystalline silicon or bi-crystal silicon can be used as a single seed crystal. Next, silicon feedstock may be added to the crucible (step 610). The crucible is then heated from the top while the bottom of the crucible is cooled from the bottom (either passively or actively; *see* step 615). During melting, the melt stage of the silicon is monitored to track and control the position of the solid-liquid interface (step 620). The melt stage of the silicon is allowed to proceed until a portion of the monocrystalline silicon seed crystals are melted (step 625). Once a desired portion of the monocrystalline silicon seed crystals are melted, the melt stage is ended and the crystal growth stage begins (step 630). The crystal growth is allowed to continue unidirectionally and vertically within the crucible until the silicon crystallization is complete (step 635). Finally, the ingot is removed for further processing (step 640).

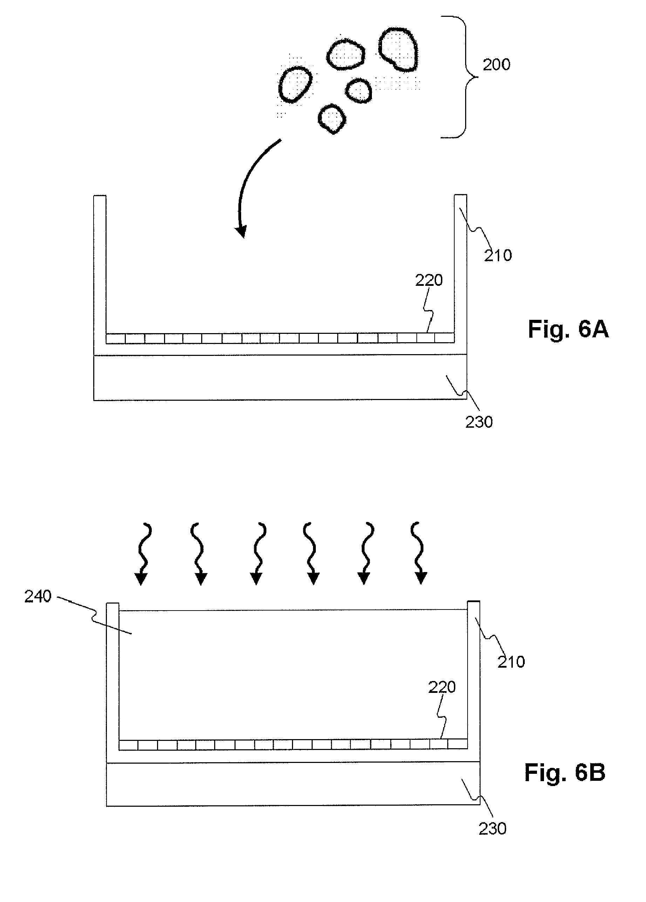

As shown in FIG. 6A, silicon feedstock 200 may be introduced to crucible 210 containing seeds 220 in, for example, one of two ways. In the first, crucible 210 is loaded to full capacity with solid silicon feedstock 200, suitably in the form of conveniently sized chunks, and the loaded crucible 210 is placed in a casting station (not shown).

As shown in FIG. 6B, the thermal profile in crucible 210 is set up so that the top of the silicon charge in crucible 110 is heated to melting, while the bottom is actively or passively cooled to maintain the solid phase of seeds 220 at the bottom of crucible 210, *i.e.,* so that they do not float when feedstock 200 is melted. A solid heat sink material 230 is in contact with a bottom of crucible 210 for radiating heat to water-cooled walls. For example, heat sink material 230 can be a solid block of graphite, and can preferably have dimensions as large or larger than the bottom of the crucible. Consistent with the invention, for example, the heat sink material can be 66 cm by 66 cm by 20 cm, when used with a crucible having a bottom surface that is 66 cm by 66 cm. The side walls of crucible 210 are, preferably, not cooled in any way, provided that seeds 220 are located only on the bottom of crucible 210. If seeds 220 are located on the bottom and sides of crucible 210, then heat sink material 230 would be placed on both the bottom and sides of crucible 210 for maintaining the desired thermal profile.

The melting phase of silicon feedstock 200 is closely monitored to track the position of the interface between the melted silicon and the seeds. Preferably, melt 240 (shown in FIG. 6B) proceeds until all of the feedstock silicon 200 except for seeds 220 is completely melted, after which seeds 220 are partially melted. For example, the heating can be closely controlled such that the seeds 220 do not melt completely, by maintaining a ΔT of about 0.1 °C/min or less, as measured on an outside surface of the crucible, after reaching the melting temperature of silicon elsewhere in the crucible. Preferably, the heating can be closely controlled by maintaining a ΔT of about 0.05 °C/min or less, as measured on an outside surface of the crucible, after reaching the melting temperature of silicon elsewhere in the crucible. For example, consistent with the invention, the ΔT can be measured on an outside surface of the crucible between the crucible and a large block of graphite, and a dip-rod may be inserted into melt 240 to measure the depth of the melt, in order to calculate the portion of seeds 220 that have melted.

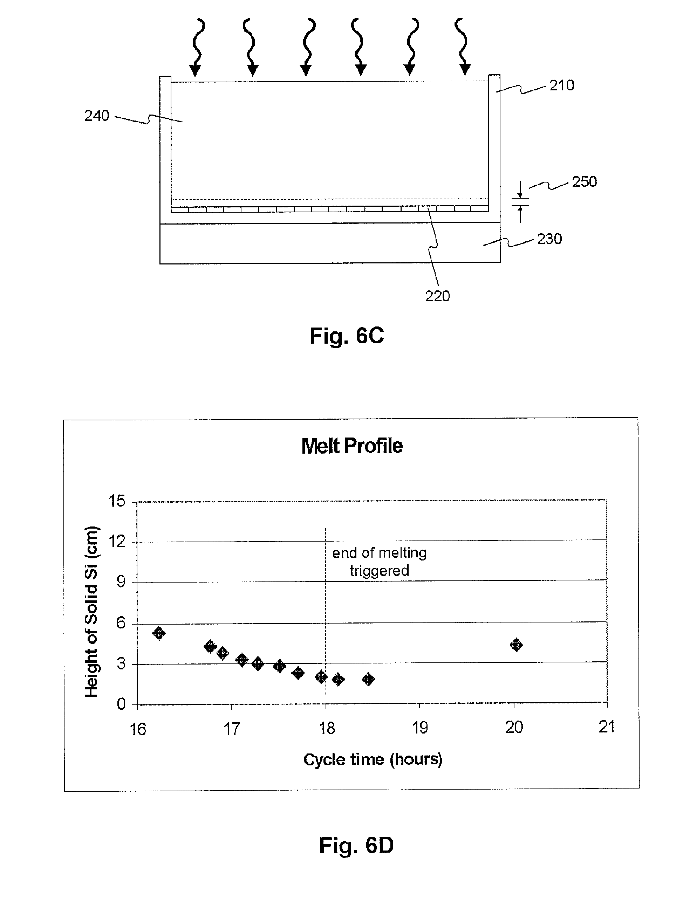

As shown in FIG. 6C, portion 250 illustrates a melted portion of the total thickness of seeds 220, below the melt 240. After a portion 250 of seeds 220 are melted below melt 240, the melt stage is then quickly ended and the crystal growth stage is begun, wherein the heating at the top of crucible 210 is decreased and/or the cooling of the bottom at heat sink material 230 is increased. As an example of this process, the chart shown in FIG. 6D illustrates melting of a portion 250 of seeds 220 as a function of time. As shown in FIG. 6D, a portion of the seeds having an initial thickness between 5 and 6 cm are gradually melted until just under 2 cm of solid seed remains. For example, the heating can be closely controlled such that the seeds 220 do not melt completely, by maintaining a ΔT of about 0.1 °C/min or less, as measured on an outside surface of the crucible (*e.g.*, through a thermocouple mounted in the cooling block), after reaching the melting temperature of silicon elsewhere in the crucible. Preferably, the heating can be closely controlled by maintaining a ΔT of about 0.05 °C/min or less, as measured on an outside surface of the crucible, after reaching the melting temperature of silicon elsewhere in the crucible. At this point, the melt stage is then quickly ended and the crystal growth stage is begun, which is indicated by the comparative rise in solid thickness measured on the ordinate of the chart.

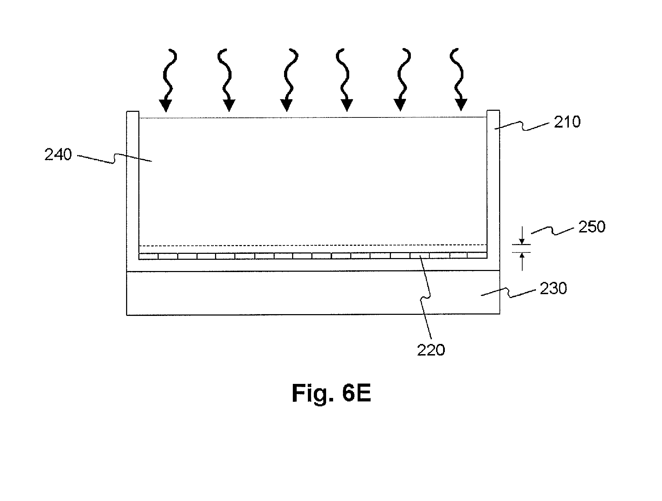

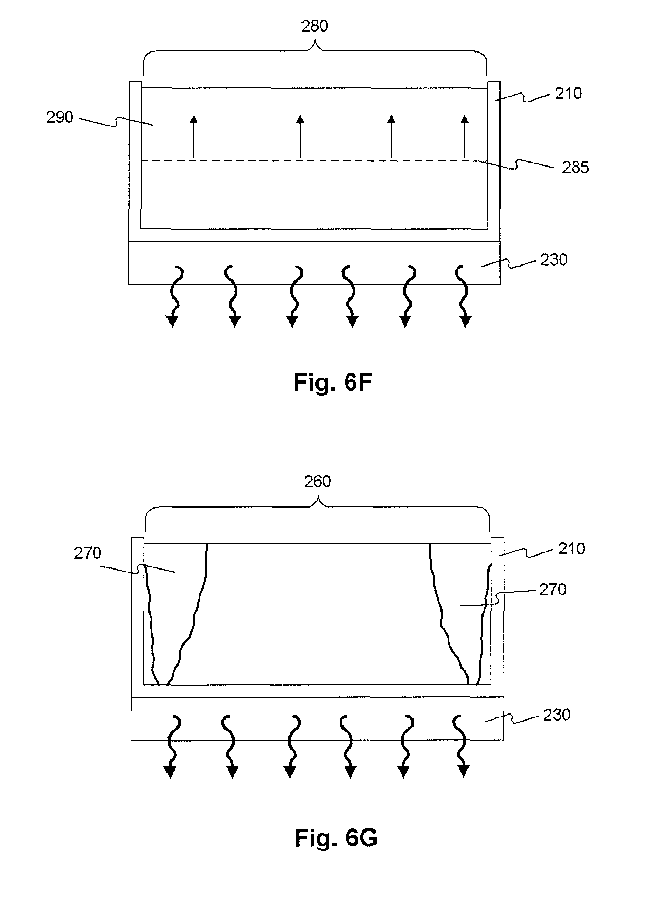

As shown in FIG. 6E, portion 250 illustrates a melted portion of the total thickness of seeds 220, below the melt 240. After a portion 250 of seeds 220 are melted below melt 240, the melt stage is then quickly ended and the crystal growth stage is begun, wherein the heating at the top of crucible 210 is decreased and/or the cooling of the bottom at heat sink material 230 is increased. Then, as shown in FIG. 6F, seeded crystal growth continues unidirectionally, and vertically, within crucible 210, as heat is drawn out through heat sink 230 until the silicon crystallization is complete. A preferably substantially flat solid-liquid interface 285 propagates upward and away from a bottom surface of crucible 210. The casting cycle finishes after the completion of crystal growth, when the top-to-bottom thermal gradient within crucible 210 is evened out. Then, the entire ingot 280 is slowly cooled down to room temperature. For casting of monocrystalline silicon, this seeded unidirectional growth produces a continuous solid body of cast monocrystalline silicon 290.

As shown in FIG. 6G, seeded crystal growth, for example, according to the seed layout or pattern of FIG. 2 continues vertically within crucible 210 until the silicon crystallization is complete. The casting cycle finishes when the top-to-bottom thermal gradient within crucible 210 is evened out. Then, the entire ingot 260 is slowly cooled down to room temperature. For casting of monocrystalline and bi-crystal silicon, as shown in FIG. 6G, the use of a surrounding pattern of (111) seeds 310 around (100) seeds 300 (as shown in FIG. 2) produces grains 270 having, for example, (111) orientation over the respective (111) seed from which they nucleated and grew. In this manner, a high quality bi-crystal of (111) and (100) crystal orientation monocrystalline silicon occupies a majority of, preferably a substantial majority of, the volume of ingot 260.

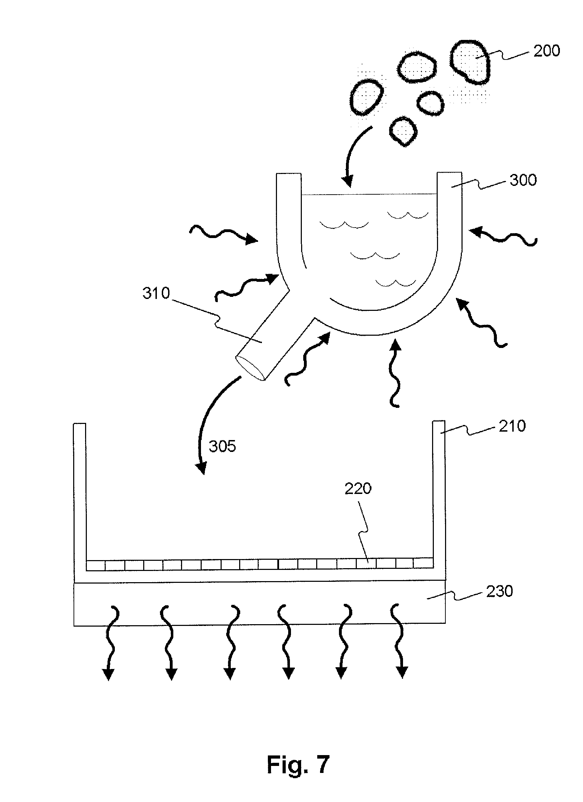

In another process, illustrated in FIG. 7, silicon feedstock 200 may be first melted in a separate compartment or separate melt vessel 300. Seeds 220 may or may not be partially melted from the top before the molten feedstock 305 is fed or poured into crucible 210 via melt pipe 310, after which cooling and growth proceeds as described with reference to Figs. 6B-6G. In another embodiment, silicon seed crystals may be mounted on the walls of crucible 210 (not shown) and seeded growth can proceed from the sides as well as the bottom of crucible 210, as described previously. Alternatively, silicon feedstock 200 is melted in a melt vessel 300 separate from crucible 210, and at the same time crucible 210 is heated to the melting temperature of silicon, and the heating is controlled so that seeds 220 do not melt completely. Upon partial melting of seeds 220, molten feedstock 305 can be transferred from melt vessel 300 into crucible 210, and the cooling and crystallization can begin. Thus, consistent with an embodiment of the invention, a portion of the solid body of crystallized silicon can include seeds 220. Alternatively, the seeds may be kept completely solid prior to melt introduction. In this case, the molten silicon in melt vessel 300 is heated beyond the melting temperature, and the superheated liquid is allowed to melt a portion of some of the seeds when the superheated liquid is introduced.

In a two-stage casting station, such as that shown in FIG. 7, molten feedstock 305 would pour down from melt vessel 300, land on seeds 220, and assume their crystallinity during solidification. Alternatively, melting may take place in a central melt vessel 300, which feeds a distributed arrangement of solidification crucibles, such as one or more copies of crucible 210 (not shown). Consistent with embodiments of the invention, the solidification crucibles can be lined with seeds 220 on either or both of the sides and bottom of the crucibles. Some advantages of this approach include: the separation of melting and solidification systems, to allow better optimization of each casting step; a semi-continuous melting of silicon, where melting of new material can occur in a regular fashion, as needed to maintain the crucible supply; slagging of the top (and potential draining of the bottom) silicon while the solidification stations are fed from the middle of the melt, enhancing purity of the starting silicon material; and allowing melt vessel 300 to come into equilibrium with molten feedstock 305 and no longer be a significant source of impurities.

Thus, after an ingot 260 or 280 has been cast by one of the methods described above, the resulting cast ingot can be processed further by, for example, cutting off the bottom or another section of the ingot and using it as a single crystal or bi-crystal seed in a subsequent casting run to form a body of monocrystalline silicon, bi-crystal silicon, or near-monocrystalline silicon, consistent with the invention, and wherein the size and shape of such single crystal seed is the same size and shape of the bottom of crucible used in the subsequent casting run, and the rest of the ingot can be cut into bricks and wafers for processing into photovoltaic cells. Alternately, the entire ingot can be cut into, for example, horizontal slabs for use as seed crystals in multiple casting stations for future casting runs.

The silicon feedstock used in processes consistent with embodiments of the invention can contain one or more dopants such as those selected from a list including: boron, aluminum, lithium, gallium, phosphorus, antimony, arsenic, and bismuth. The total amount of such dopant can be about 0.01 parts per million by atomic % (ppma) to about 2 ppma. The total amount of such dopant or dopants can be about 0.01 parts per million (ppm) by atomic % (ppma) to about 2 ppma. Preferably, the amount of dopant or dopants in the silicon is an amount such that a wafer made from the silicon has a resistivity of about 0.1 to about 50 ohm-cm, preferably of about 0.5 to about 5.0 ohm-cm. Alternately, other materials having a suitable liquid phase can be cast using the processes and apparatuses disclosed here. For example, germanium, gallium arsenide, silicon germanium, sapphire, and a number of other III-V or II-VI materials, as well as metals and alloys, could be cast according to embodiments of the present invention.

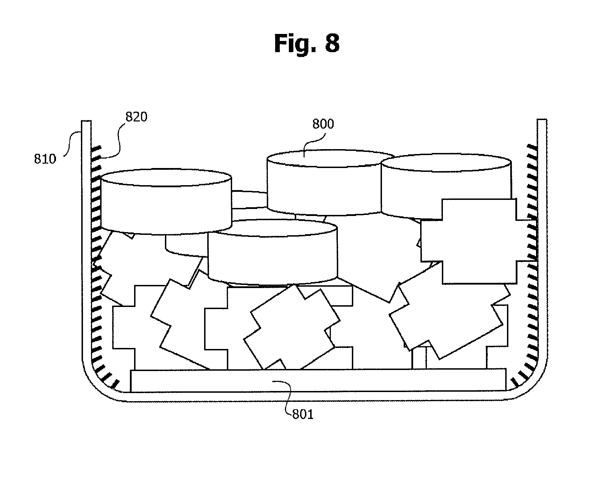

FIG. 8 illustrates a cross-section of silicon (feedstock 800 and crystalline seeds 801) loaded into crucible 810 for casting. Release coating 820, such as silicon nitride or silicon carbide, may be applied to areas of crucible 810 where feedstock 800 contacts crucible 810, which corresponds to areas of silicon 800 that will become completely melted during casting. No coating has been applied below crystalline seeds 801. Seeds 801 will not be completely melted and thus will not adhere to crucible 810.

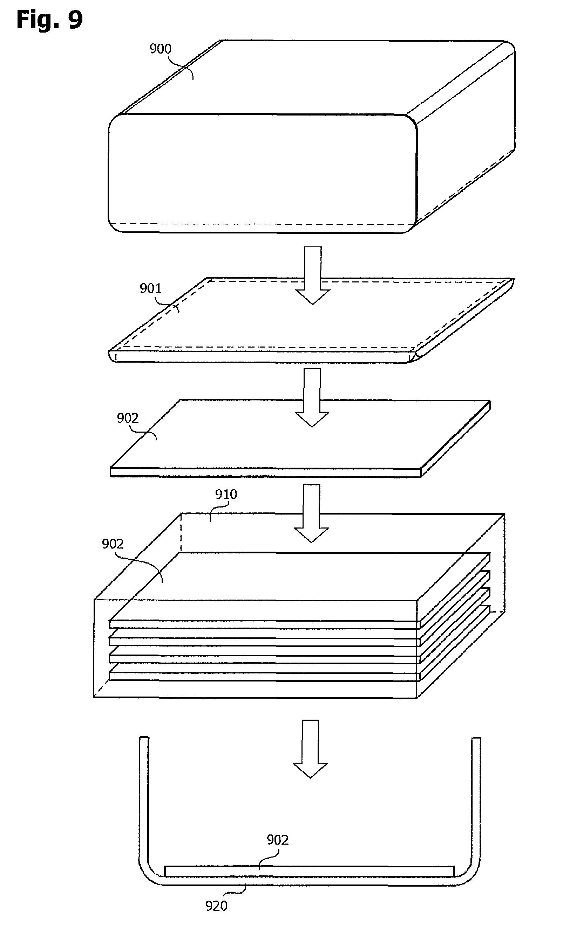

FIG. 9 illustrates a process for the reuse of a crystalline silicon seed layer. As shown in FIG. 9, cast ingot 900 grown from seed layer 901 is first sliced along the dotted lines to remove a slab of material containing seed layer 901. The slab of material is then trimmed at the dotted edges to remove excess material that might interfere with its placement in another crucible. Trimmed slab 902, having been trimmed to the size and shape of original seed layer 901, is then treated, potentially with other similar pieces of silicon, in a container 910, such as a tank or a tub containing a suitable liquid or other material, to remove contaminants and debris from layer 901 (and possibly other pieces of silicon) before being placed in a new crucible 920 for use as a seed layer in a subsequent casting process.

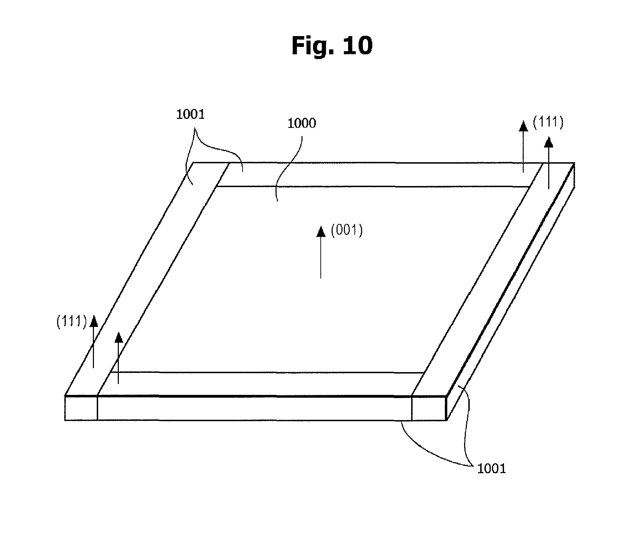

FIG. 10 illustrates an exemplary arrangement of single crystal silicon pieces arranged to form a seed layer. The (001) crystal orientation has been shown to have advantageous properties for the manufacture of silicon solar cells. (001) silicon may be chemically etched in such a way as to produce a pattern pyramids covering its entire surface, which can improve the light-trapping ability of the silicon by both decreasing reflection and increasing the path length of light in the material. Chemical etching may be accomplished by known methods. However, the casting of (001) silicon is made difficult by its tendency to grow grain boundaries at acute angles to its (001) pole direction when located next to a multicrystalline region of silicon. To counteract the growth of multicrystalline silicon, a geometric arrangement of a plurality of monocrystalline silicon seed crystals can be placed on at least one surface in a crucible (not shown), e.g., a bottom surface of a crucible, wherein the geometric arrangement includes close-packed polygons. As shown in FIG. 10, a piece of (001) silicon 1000 is surrounded by a periphery of rectangles of (111) silicon 1001. The pole orientation of the peripheral silicon 1001 is shown as (111), but it could be any crystal orientation that is competitively favored when grown next to a multicrystalline region. In this way, the majority of a resulting cast ingot (not shown) will be composed of (001) silicon, and the competitively favored (111) grains grown from silicon 1001 will limit the growth of multicrystalline silicon in the region occupied by (001) silicon over silicon 1000. Similarly, silicon crystal grains produced by casting a body of multi-crystalline silicon, consistent with embodiments of the invention, may be grown in a columnar manner. Further, such crystal grains may have a cross section that is, or is close to, the shape of the seed from which it is formed, instead of having an (001) cross-sectional area that shrinks as solidification proceeds. When making silicon that has such specifically selected grain boundaries, preferably the grain boundary junctions only have three grain boundaries meeting at a corner, a condition met in the arrangement shown in FIG. 10.

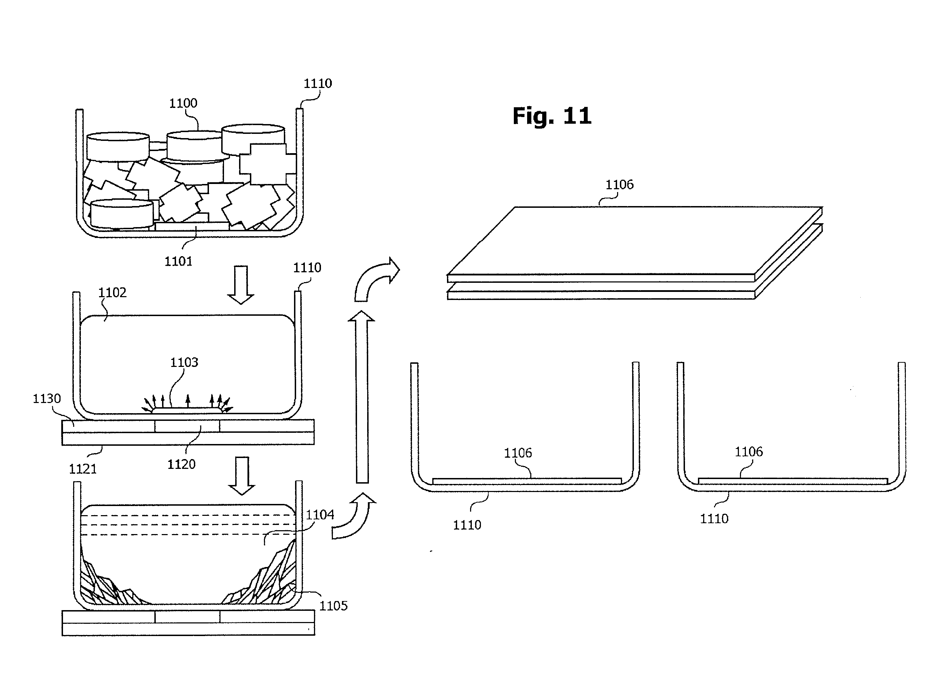

FIG. 11 illustrates a process for manufacturing large area, dislocation-free single crystals for use as seed layers. In this process, depicted in cross-section, polycrystalline feedstock 1100 is loaded together with a single crystal seed 1101 which may have lateral dimensions from about 25 cm² to about 10,000 cm² in area and a thickness from about 3 mm to about 1000 mm. Feedstock 1100 is placed in crucible 1110, which is then placed in a station (not shown) on top of layers 1120, 1121, and 1130, composed of thermally conducting (1120) and thermally insulating (1130) parts. The area of the thermally conducting parts 1120 should preferably be about the same shape of bottom of crucible 1110, having a lateral area from about 50% to about 150% that of seed crystal 1101. During melting, heat is extracted through thermally conducting area 1120 to a support plate 1121, while heat is prevented from passing through thermally insulating layer 1130. Heat is conducted out through thermally conducting area 1120 even during the melting phase of casting, in order to prevent the complete melting of seed crystal 1101. Once all feedstock 1100 and a small portion of seed crystal 1101 are melted into liquid silicon 1102, remaining solid silicon 1103 then acts as the nucleation layer for the solidification process. The presence of insulating layer 1130 helps control the shape of solid silicon 1103 during nucleation and growth, as well as the direction of solidification, indicated by arrows in FIG. 11. The strong curvature in the solidification surface causes an outward growth of solid silicon 1103, while multicrystalline regions 1105 are minimized. Once ingot 1104 is cast, horizontal layers may be cut (dashed lines) from the upper parts of the ingot to be used as new seed slabs 1106. Slabs 1106 can be cleaned, trimmed, and used as a complete seed layer for a new ingot in a new crucible 1110, or as a starting point for an even larger single crystal, again using the process just described.

Moreover, although casting of silicon has been described herein, other semiconductor materials and nonmetallic crystalline materials may be cast without departing from the scope and spirit of the invention. For example, the inventors have contemplated casting of other materials consistent with embodiments of the invention, such as germanium, gallium arsenide, silicon germanium, aluminum oxide (including its single crystal form of sapphire), gallium nitride, zinc oxide, zinc sulfide, gallium indium arsenide, indium antimonide, germanium, yttrium barium oxides, lanthanide oxides, magnesium oxide, calcium oxide, and other semiconductors, oxides, and intermetallics with a liquid phase. In addition, a number of other group III-V or group II-VI materials, as well as metals and alloys, could be cast according to embodiments of the present invention.

The first temperature, such as a range of between about 1410 °C and about 1300 °C usually includes a temperature gradient across and/or through the solid body. The second temperature, such as about 1350 °C on average usually includes a reduced temperature gradient and/or a uniform temperature profile across and/or through the solid body. The reducing the temperature gradient may be referred to sometimes as annealing in the context of this disclosure. Annealing may include closing up the insulation, for example.

In some embodiments, a method of manufacturing cast silicon includes placing molten silicon in contact with a pattern of seed crystals in a vessel having one or more side walls heated to at least a melting temperature of silicon and at least one wall for cooling. The cooling wall may be one or more side walls and/or a bottom surface of the vessel or crucible, for example.

Desirably, the pattern of seed crystals includes a plurality of single crystal silicon seed crystals, where one or more of the single crystal silicon seed crystals are arranged with a first crystal orientation, and one or more of the single crystal silicon seed crystals are arranged with a second crystal orientation. In some embodiments, the pattern covers an entire or substantially an entire area and/or portion of an interior surface of the vessel or crucible.

The method may further include forming a solid body including a region of monocrystalline silicon. Desirably, the solid body or ingot includes a substantial portion of monocrystalline silicon. Alternately, the forming may include a solid body with a region of bi-crystal silicon. The solid body may include any suitable dimension and generally larger economies of scale are desired, while maintaining sufficient purity and/or crystallinity. The solid body may include at least two dimensions of each at least about 10 cm, at least about 25 cm, at least about 35 cm, and/or at least about 50 cm.

The solid body may also include the plurality of single crystal silicon seed crystals, such as may be used in subsequent casting processes. Alternately, the method may include forming another solid body of silicon using a seed crystal cut from a body of silicon previously cast according to this method.

The forming may further include cooling the molten silicon to control crystallization, such as forming a solid-liquid interface at an edge of the molten silicon that at least initially parallels the at least one wall for cooling, where the solid-liquid interface can be controlled during cooling to move in a direction increasing a distance between the molten silicon and the at least one wall for cooling. Put another way, the solidification front advances away from the cooling source. The cooling source and/or heat sink may cause the solidification front to advance in any suitable direction, such as generally horizontally and/or generally vertically. Desirably, the cooling includes using a heat sink material for radiating heat to water-cooled walls, for example.

In some embodiments, the placing further includes placing the plurality of single crystal silicon seed crystals in a bottom of a crucible with an arrangement of the first crystal orientation surrounded, encircled, and/or bordered by an arrangement of the second crystal orientation. The method may further include where cooling moves the solid-liquid interface in a direction away from the bottom of the crucible while maintaining an edge that parallels the at least one wall for cooling.

In some embodiments, a border of seed crystals having a (111) orientation surrounds the plurality of single crystal silicon seed crystals having a (100) orientation. Desirably, the (100) orientation reduces and/or prevents multicrystalline silicon from growing and/or forming on the sidewalls and extending inwards, for example.

In some embodiments, the placing molten silicon further includes melting silicon feedstock in a melt container separate from the crucible, heating the crucible and the silicon to at least the melting temperature of silicon, controlling the heating so that the plurality of single crystal silicon seed crystals in the crucible does not melt completely, and transferring the molten silicon from the melt container into the crucible. Utilizing a separate and/or dedicated melt container may provide increased capacity and/or production, for example.

In some embodiments, the placing molten silicon further includes heating the crucible and the silicon to the melting temperature of silicon, and controlling the heating to maintain a ΔT of about 0.1 °C/min or less, as measured on an outside surface of the crucible, after reaching the melting temperature of silicon elsewhere in the crucible. The ΔT refers to the rate of change of temperate with respect to time.

In some embodiments, a method of manufacturing cast silicon includes: placing silicon feedstock in contact with a pattern of silicon seed crystals having monocrystalline silicon on at least one surface. The pattern comprises a plurality of single crystal silicon seed crystals, where one or more of the single crystal silicon seed crystals are arranged with a first crystal orientation, and one or more of the single crystal silicon seed crystals are arranged with a second crystal orientation. The method further includes heating the silicon feedstock and the pattern of silicon seed crystals to the melting temperature of silicon and controlling the heating so that the pattern of silicon seed crystals does not melt completely. Desirably, the controlling includes maintaining a ΔT of about 0.1 °C/min or less, as measured on an outside surface of the crucible. After reaching and/or attaining the melting temperature of silicon elsewhere in the crucible and, once the pattern of silicon seed crystals is partially melted, the method may include forming a solid body including monocrystalline silicon by cooling the silicon. Alternately, the forming further includes forming a solid body having a region of bi-crystal silicon in place of and/or in addition to the monocrystalline silicon. The forming may also include a portion of the solid body to have a plurality of single crystal silicon seed crystals.

As used herein the terms "having", "comprising", and "including" are open and inclusive expressions. Alternately, the term "consisting" is a closed and exclusive expression. Should any ambiguity exist in construing any term in the claims or the specification, the intent of the drafter is toward open and inclusive expressions.

The method may also include placing the plurality of single crystal silicon seed crystals in a bottom of a crucible so an arrangement of the second crystal orientation at least partially and/or completely surrounds an arrangement of the first crystal orientation.

In some embodiments, the invention includes a body of bi-crystal silicon being free and/or substantially free of radially-distributed impurities and defects. Desirably, the body includes at least two dimensions that are each at least about 25 cm and a third dimension at least about 20 cm. Alternately, the continuous cast bi-crystal silicon includes at least two dimensions each at least about 35 cm and/or at least about 50 cm.

The body may have a carbon concentration of about 2x10¹⁶ atoms/cm³ to about 5x10¹⁷ atoms/cm³, an oxygen concentration not exceeding 5x10¹⁷ atoms/cm³, and a nitrogen concentration of at least 1x10¹⁵ atoms/cm³, for example. Other ranges of carbon, oxygen and nitrogen are possible. Desirably, the body is free and/or substantially free of swirl defects and/or substantially free of oxygen-induced stacking fault defects.

In some embodiments, a solar cell of this invention includes a wafer formed from a body of continuous bi-crystal silicon being free or substantially free of radially-distributed impurities and defects. The body includes at least two dimensions that are each at least about 25 cm and a third dimension at least about 20 cm. The solar cell may further include a p-n junction in the wafer, and electrically conductive contacts on the wafer. Alternately, the body of continuous cast bi-crystal silicon includes at least two dimensions that are each at least about 35 cm. Desirably, the body is free and/or substantially free of radially-distributed defects and/or oxygen-induced stacking fault defects.

In some embodiments, the invention includes a wafer of silicon formed from a body of continuous bi-crystal silicon being free or substantially free of radially-distributed impurities and defects, where the body has at least two dimensions that are each at least about 25 cm and a third dimension at least about 20 cm. Alternately, the wafer may include at least one dimension that is at least about 50 mm, and/or the body may include at least two dimensions that are each at least about 25 cm and a third dimension at least about 20 cm.

In some embodiments, a method of manufacturing cast silicon includes: coating inner side walls of a crucible with a release coating and leaving a bottom surface uncoated. The method may also include placing silicon seed crystals in contact with the uncoated bottom surface and placing silicon feedstock in the crucible. The method may also include melting the silicon feedstock while maintaining the seed crystals in an at least partially solid state, and forming a solid body of silicon by extracting heat through the seed crystals. The method may also include bringing the body to a first temperature, and cooling the body to a second temperature. Alternately, the entire and/or substantially the entire interior surface of the crucible and/or vessel may be coated with the release coating.

The method may also include slicing a previously cast body into at least one slab, and chemically treating the at least one slab to remove impurities. The method may also include placing the at least one slab as a seed layer in at least one crucible and placing molten silicon in contact with the seed layer. The method may also include forming a solid body of silicon by extracting heat through the bottom of the crucible, bringing the body to a first temperature, and cooling the body to a second temperature.

The step of chemically treating may include any suitable procedure to remove and/or reduce impurities. Desirably, the chemical treatment removes metals and/or residual metals. Chemical treatment may include a caustic dip, such as placing the silicon in a sodium hydroxide solution to remove metals for about 30 minutes followed by a rinse with deionized water, for example. The chemical treatment may also include an acid dip, such as placing the silicon in a hydrochloric acid solution to remove residual metals, for example. The silicon may be rinsed with deionized water and dried, for example. The chemical treatment may be automated with a machine and/or be performed manually.

In some embodiments, a method of manufacturing cast silicon includes: placing a layer of monocrystalline silicon seed crystals on at least one surface in a crucible such that a center seed crystals of the layer have one primary crystal pole direction and cover about 50% to about 99% of a seed layer area, while the seed crystals on a edge of the layer have at least one different crystal pole direction and cover a remaining area. The method may also include introducing feedstock silicon and bringing the feedstock silicon and some of the seed layer to a molten state. The method may also include forming a solid body of silicon by extracting heat through the seed layer and a portion of the crucible contacting the seed layer. The method may also include bringing the solid body to a first temperature, and cooling the solid body to a second temperature.

In some embodiments, a method of manufacturing cast silicon includes: placing at least one monocrystalline seed crystal of at least about 10 cm by about 10 cm area on the bottom of a crucible that rests on a partially insulating base plate. The method may also include placing liquid silicon in contact with the at least one seed crystal and forming a solid body of silicon by extracting heat through the seed crystal in such a way that a convex solid boundary increases a cross-sectional area of monocrystalline growth. The method may also include bringing the body to a first temperature, and cooling the body to a second temperature. The method may also include cutting a slab from the side of the body opposite the seed crystal; cleaning the slab using a chemical process, and using the slab as a seed layer for a subsequent casting process.

The following examples are experimental results consistent with embodiments of the invention. These examples are presented for merely exemplifying and illustrating embodiments of the invention and should not be construed as limiting the scope of the invention in any manner.

Example 1

Crucible preparation: A crucible was placed on a supporting structure consisting of two layers. The bottom layer of the supporting structure is a solid isomolded graphite plate measuring 80 cm by 80 cm by 2.5 cm which supported a composite layer. The upper composite layer had an inner region that was a thermally conducting isomolded graphite plate measuring 60 cm by 60 cm by 1.2 cm, and was surrounded on all sides by a 10 cm perimeter of thermally insulating graphite fiber board of 1.2 cm thickness. In this way, the composite layer completely covered the bottom layer.

Seed preparation: A boule of pure Czochralski (CZ) silicon (monocrystalline), obtained from MEMC, Inc. and having 0.3 ppma of boron, was cut down along its length using a diamond coated band saw so that it had a square cross section measuring from 140 mm per side. The resulting block of monocrystalline silicon was cut through its cross section using the same saw into slabs having a thickness of about 2 cm to about 3 cm. These slabs were used as monocrystalline silicon seed crystals, or "seeds." The (100) crystallographic pole orientation of the silicon boule was maintained. The resulting single crystal silicon slabs were then arranged in the bottom of a quartz crucible so that the (100) direction of the slabs faced up, and the (110) direction was kept parallel to one side of the crucible. The quartz crucible had a square cross section with 68 cm on a side and a depth of about 40 cm. The slabs were arranged in the bottom of the crucible with their long dimension parallel to the bottom of the crucible and their sides touching to form a single, complete layer of such slabs on the bottom of the crucible.

Casting: The crucible was loaded with the seed plates and then filled up to a total mass of 265 kg of solid silicon feedstock at room temperature. A few wafers of highly boron doped silicon were added to provide enough boron for a total ingot doping of ∼0.3 ppma. The filled crucible was first surrounded with graphite support plates that rested on the thermally insulating portion of the support structure, and was then loaded into an in-situ melting/directional solidification casting station used to cast multi-crystalline silicon. The melt process was run by heating resistive heaters to approximately 1550 °C, and the heaters were configured so that the heating came from the top while heat was allowed to radiate out the bottom by opening the insulation a total of 6 cm. This configuration caused the melting to proceed in a top-down direction towards the bottom of the crucible. The passive cooling through the bottom caused the seed crystals to be maintained in solid state at the melting temperature, as was monitored by a thermocouple. The extent of melting was measured by a quartz dip rod that was lowered into the melt every ten minutes. The dip rod height was compared with a measurement taken on an empty crucible in the station to determine the height of the remaining solid material. By dip rod measurement, first the feedstock melted, and then the melting phase was allowed to continue until only a height of about 1.5 cm of the seed crystals remained. At this point, the heating power was dropped to a temperature setting of 1500 °C, while the radiation from the bottom was increased by opening the insulation to 12 cm. One or two additional millimeters of seed crystals melted before solidification began, as observed by dip-rod measurements. Then seeded single crystal growth proceeded until the end of the solidification step. The growth stage and the remainder of the casting cycle was performed with the normal parameters where the top-to-bottom thermal gradient is evened out, and then the entire ingot is slowly cooled to room temperature. The cast silicon product was a 66 cm by 66 cm by 24 cm ingot. The region of crystallinity consistent with the seeds began at the bottom and conformed with the edge of the unmelted material, and from there grew laterally outwards toward the crucible walls as growth began, and stabilized to a constant size towards the end of crystallization. The monocrystalline silicon structure was evident from visually inspecting the faces of bricks cut from the ingot.

Example 2

Seeding was accomplished as in Example 1, and an ingot was cast containing a large monocrystalline volume. After cooling, the ingot was stood on its side and loaded into a band saw with fixed diamond abrasive for cutting. The bottom of the ingot was cut off as a single layer with a thickness of 2 cm. This layer was then fixed horizontally on a cutting table. In the same band saw, the edges of the layer were trimmed such that approximately 1.5 cm was removed from each side. The slab was then sandblasted to remove glue and foreign materials, after which it was etched in a hot sodium hydroxide bath, rinsed, and dipped in a HCl bath to remove metals. The slab was then placed on the bottom of a standard crucible of the same size as the previous ingot. Silicon feedstock was loaded to a total mass of 265 kg and the casting process was repeated, producing a second seeded ingot.

Example 3

Seed preparation: A seed layer was prepared, starting with 18 kg of square, (100), plates used to line the bottom of a crucible, providing a coverage area of 58 by 58 cm and a thickness ranging from 2-3 cm. These plates were placed together into a larger square that was centered in the crucible. Next, this square was surrounded by a 2 cm thick layer of (111) oriented seed crystals, making the total seed layer a 63 cm by 63 cm square.

Casting: The crucible containing the seeds was filled with silicon to a total mass of 265 kg and placed in a casting station. Casting was performed as in Example 1, monitoring the process to assure that the seed layer remained intact through the end of melt and beginning of solidification. The resulting ingot was cut into a 5x5 grid of 12.5 cm bricks. Optical inspection of the crystal structure of the bricks showed that the (111) crystals acted as a buffer layer, preventing the ingress of randomly nucleated grains into the (100) volume.

Thus, consistent with embodiments of the present invention and the examples described above, the silicon can be a body of cast continuous monocrystalline silicon, cast bi-crystal silicon, or cast near-monocrystalline silicon, that preferably is essentially free of, or free of, radially distributed defects such as OSF's and/or swirl defects, and, preferably, where at least two dimensions of the body are preferably at least about 10 cm, preferably at least about 20 cm, more preferably at least 30 cm, still more preferably at least 40 cm, still more preferably at least 50 cm, still more preferably at least 60 cm, and most preferably at least about 70 cm. Most preferably, the third dimension of such a body of silicon is at least about 5 cm, preferably at least about 15 cm and most preferably at least about 20 cm. The body of silicon can be one separate piece as a single body, or it can be contained within or surrounded by, totally or partially, other silicon. The body of silicon can be formed preferably having at least two dimensions each being as large as the interior dimensions of a casting vessel. As disclosed herein, embodiments of the invention can be used to produce large bodies of monocrystalline silicon, bi-crystal silicon, or near-monocrystalline silicon by a simple and cost-effective casting process.

Wafers made from the silicon consistent with embodiments of the invention are suitably thin and can be used in photovoltaic cells. Furthermore, the wafers can be n-type or p-type. For example, wafers can be about 10 microns thick to about 700 microns thick. Further, the wafers used in the photovoltaic cells preferably have a diffusion length (Lₚ) that is greater than the wafer thickness (t). For example, the ratio of Lₚ to t is suitably at least 0.5. It can, for example, be at least about 1.1, or at least about 2. The diffusion length is the average distance that minority carriers (such as electrons in p-type material) can diffuse before recombining with the majority carriers (holes in p-type material). The Lₚ is related to the minority carrier lifetime τ through the relationship Lₚ = (Dτ)^{1/2}, where D is the diffusion constant. The diffusion length can be measured by a number of techniques, such as the Photon-Beam-Induced Current technique or the Surface Photovoltage technique. See for example, "Fundamentals of Solar Cells", by A. Fahrenbruch and R. Bube, Academic Press, 1983, pp. 90-102, for a description of how the diffusion length can be measured.

The wafers can have a width of about 100 millimeters to about 600 millimeters. Preferably, the wafers have at least one dimension being at least about 50 mm. The wafers made from the silicon of the invention, and consequently the photovoltaic cells made by the invention can, for example, have a surface area of about 50 to about 3600 square centimeters. The front surface of the wafer is preferably textured. For example, the wafer can be suitably textured using chemical etching, plasma etching, or laser or mechanical scribing. If a wafer having a (100) pole orientation is used, the wafer can be etched to form an anisotropically textured surface by treating the wafer in an aqueous solution of a base, such as sodium hydroxide, at an elevated temperature, for example about 70°C to about 90°C, for about 10 to about 120 minutes. The aqueous solution may contain an alcohol, such as isopropanol.

Thus, solar cells can be manufactured using the wafers produced from cast silicon ingots according to the embodiments of the invention, by slicing the solid body of cast silicon to form at least one wafer; optionally performing a cleaning procedure on a surface of the wafer; optionally performing a texturing step on the surface; forming a p-n junction, for example, by doping the surface; optionally depositing an anti-reflective coating on the surface; optionally forming at least one layer selected from a back surface field and a passivating layer by, for example, an aluminum sintering step; and forming electrically conductive contacts on the wafer. A passivating layer is a layer that has an interface with a bare wafer surface that ties up the dangling bonds of the surface atoms. Examples of passivating layers on silicon include silicon nitride, silicon dioxide and amorphous silicon. This layer is generally thinner than one micron, either being transparent to light or acting as an anti-reflective layer.

In a typical and general process for preparing a photovoltaic cell using, for example, a p-type silicon wafer, the wafer is exposed on one side to a suitable n-dopant to form an emitter layer and a p-n junction on the front, or light-receiving side of the wafer. Typically, the n-type layer or emitter layer is formed by first depositing the n-dopant onto the front surface of the p-type wafer using techniques commonly employed in the art such as chemical or physical deposition and, after such deposition, the n-dopant, for example, phosphorus, is driven into the front surface of the silicon wafer to further diffuse the n-dopant into the wafer surface. This "drive-in" step is commonly accomplished by exposing the wafer to high temperatures. A p-n junction is thereby formed at the boundary region between the n-type layer and the p-type silicon wafer substrate. The wafer surface, prior to the phosphorus or other doping to form the emitter layer, can be textured. In order to further improve light absorption, an optional anti-reflective coating, such as silicon nitride, can be typically applied to the front of the wafer, sometimes providing simultaneous surface and or bulk passivation.

In order to utilize the electrical potential generated by exposing the p-n junction to light energy, the photovoltaic cell is typically provided with a conductive front electrical contact on the front face of the wafer and a conductive back electrical contact on the back face of the wafer, although both contacts can be on the back of the wafer. Such contacts are typically made of one or more highly electrically conducting metals and are, therefore, typically opaque.

Thus, solar cells consistent with the embodiments described above may comprise a wafer formed from a body of continuous monocrystalline silicon, bi-crystal silicon, or near-monocrystalline silicon being free or substantially free of radially-distributed defects, the body can be as described hereinabove, and, for example, having at least two dimensions each being at least about 25 cm and a third dimension being at least about 20 cm, a p-n junction in the wafer, an optional anti-reflective coating on a surface of the wafer; preferably having at least one layer selected from a back surface field and a passivating layer; and electrically conductive contacts on the wafer, wherein the body may be free or substantially free of swirl defects and free or substantially free of OSF defects.

It will be apparent to those skilled in the art that various modifications and variations can be made in the disclosed structures and methods without departing from the scope or spirit of the invention. For example, the disclosed processes and methods that relate to forming monocrystalline silicon are also applicable to forming bi-crystal silicon or near-monocrystalline silicon, or combinations thereof. Moreover, although casting of silicon has been described herein, other semiconductor materials and nonmetallic crystalline materials may be cast without departing from the scope and spirit of the invention. For example, the inventor has contemplated casting of other materials consistent with embodiments of the invention, such as gallium arsenide, silicon germanium, aluminum oxide, gallium nitride, zinc oxide, zinc sulfide, gallium indium arsenide, indium antimonide, germanium, yttrium barium oxides, lanthanide oxides, magnesium oxide, and other semiconductors, oxides, and intermetallics with a liquid phase. Other embodiments of the invention will be apparent to those skilled in the art from consideration of the specification and practice of the invention disclosed herein. It is intended that the specification and examples be considered exemplary only, with a true scope and spirit of the invention being indicated by the following claims.

The present inventions are also defined by way of following clauses:
1. A method of manufacturing cast silicon, comprising:
   placing molten silicon in contact with a pattern of seed crystals in a vessel having one or more side walls heated to at least a melting temperature of silicon and at least one wall for cooling,
   wherein the pattern of seed crystals comprises a plurality of single crystal silicon seed crystals, where one or more of the single crystal silicon seed crystals are arranged with a first crystal orientation, and one or more of the single crystal silicon seed crystals are arranged with a second crystal orientation; and
   forming a solid body comprising a region of monocrystalline silicon.
2. The method according to clause 1, wherein the solid body comprises at least two dimensions of each at least about 10 cm.
3. The method according to clause 1, wherein the forming further comprises forming a solid body comprising a region of bi-crystal silicon.
4. The method according to clause 1, wherein the forming further comprises cooling the molten silicon to control crystallization, including forming a solid-liquid interface at an edge of the molten silicon that at least initially parallels the at least one wall for cooling, the solid-liquid interface controlled during a cooling to move in a direction increasing a distance between the molten silicon and the at least one wall for cooling.
5. The method according to clause 1,
   wherein the placing further includes placing the plurality of single crystal silicon seed crystals in a bottom of a crucible with an arrangement of the first crystal orientation surrounded by an arrangement of the second crystal orientation, and
   further wherein the cooling moves the solid-liquid interface in a direction away from the bottom of the crucible while maintaining an edge that parallels the at least one wall for cooling.
6. The method according to clause 5, wherein a border of seed crystals comprising a (111) orientation surrounds the plurality of single crystal silicon seed crystals comprising a (100) orientation.
7. The method according to clause 5, wherein the placing molten silicon further includes melting silicon feedstock in a melt container separate from the crucible, heating the crucible and the silicon feedstock to the melting temperature of silicon, controlling the heating so that the plurality of single crystal silicon seed crystals in the crucible does not melt completely, and transferring the molten silicon from the melt container into the crucible.
8. The method according to clause 5, further including forming a portion of the solid body to include the plurality of single crystal silicon seed crystals.
9. The method according to clause 1, wherein the cooling includes using a heat sink material for radiating heat to water-cooled walls.
10. The method according to clause 1, further comprising forming another solid body of silicon using a seed crystal cut from a body of silicon previously cast according to said method.
11. The method according to clause 1, wherein the placing molten silicon further includes heating a crucible and the silicon to the melting temperature of silicon, and controlling the heating to maintain a ΔT of about 0.1 °C/min or less, as measured on an outside surface of the crucible, after reaching the melting temperature of silicon elsewhere in the crucible.
12. The method according to clause 1, wherein the pattern covers an entire or substantially an entire area of a surface of the vessel.
13. A method of manufacturing cast silicon, comprising:
   placing silicon feedstock in contact with a pattern of silicon seed crystals comprising monocrystalline silicon on at least one surface,
   wherein the pattern comprises a plurality of single crystal silicon seed crystals, where one or more of the single crystal silicon seed crystals are arranged with a first crystal orientation, and one or more of the single crystal silicon seed crystals are arranged with a second crystal orientation;
   heating the silicon feedstock and the pattern of silicon seed crystals to the melting temperature of silicon;
   controlling the heating so that the pattern of silicon seed crystals does not melt completely, the controlling comprising maintaining a ΔT of about 0.1 °C/min or less, as measured on an outside surface of the crucible, after reaching the melting temperature of silicon elsewhere in the crucible; and, once the pattern of silicon seed crystals is partially melted; and
   forming a solid body comprising monocrystalline silicon by cooling the silicon.
14. The method according to clause 13, wherein the forming further comprises forming a solid body comprising a region of bi-crystal silicon.
15. The method according to clause 13, wherein the placing further includes placing the plurality of single crystal silicon seed crystals in a bottom of a crucible so an arrangement of the second crystal orientation surrounds an arrangement of the first crystal orientation.
16. The method according to clause 13, further including forming a portion of the solid body to include a plurality of single crystal silicon seed crystals.
17. A body of bi-crystal silicon being free or substantially free of radially-distributed impurities and defects, and having at least two dimensions that are each at least about 25 cm and a third dimension at least about 20 cm.
18. A body according to clause 17 having a carbon concentration of about 2x10¹⁶ atoms/cm³ to about 5x10¹⁷ atoms/cm³, an oxygen concentration not exceeding 5x10¹⁷ atoms/cm³, and a nitrogen concentration of at least 1x10¹⁵ atoms/cm³.
19. The body according to clause 17, wherein the body is free or substantially free of swirl defects and substantially free of oxygen-induced stacking fault defects.
20. The body according to clause 17, wherein the continuous cast bi-crystal silicon comprises at least two dimensions each at least about 35 cm.
21. A solar cell, comprising:
   a wafer formed from a body of continuous bi-crystal silicon being free or substantially free of radially-distributed impurities and defects, the body having at least two dimensions that are each at least about 25 cm and a third dimension at least about 20 cm;
   a p-n junction in the wafer; and
   electrically conductive contacts on the wafer.
22. The solar cell according to clause 21, wherein the body of continuous cast bi-crystal silicon comprises at least two dimensions that are each at least about 35 cm.
23. The solar cell according to clause 21, wherein the body is free or substantially free of radially-distributed defects.
24. The solar cell according to clause 21, wherein the body of continuous cast bi-crystal silicon comprises at least one dimension of at least about 50 mm, and the body comprises at least two dimensions each of at least about 25 cm and a third dimension of at least about 20 cm.
25. A wafer, comprising: silicon formed from a body of continuous bi-crystal silicon being free or substantially free of radially-distributed impurities and defects, the body having at least two dimensions that are each at least about 25 cm and a third dimension at least about 20 cm.
26. The wafer according to clause 25, wherein the wafer comprises at least one dimension that is at least about 50 mm, and the body comprises at least two dimensions that are each at least about 25 cm and a third dimension at least about 20 cm.
27. A method of manufacturing cast silicon, comprising:
   coating inner side walls of a crucible with a release coating and leaving a bottom surface uncoated;
   placing silicon seed crystals in contact with the uncoated bottom surface;
   placing silicon feedstock in the crucible;
   melting the silicon feedstock while maintaining the seed crystals in an at least partially solid state;
   forming a solid body of silicon by extracting heat through the seed crystals;
   bringing the body to a first temperature; and
   cooling the body to a second temperature.
28. A method of manufacturing cast silicon, comprising:
   slicing a previously cast body into at least one slab;
   chemically treating the at least one slab to remove impurities;
   placing the at least one slab as a seed layer in at least one crucible;
   placing molten silicon in contact with the seed layer;
   forming a solid body of silicon by extracting heat through the bottom of the crucible;
   bringing the solid body to a first temperature; and
   cooling the solid body to a second temperature.
29. A method of manufacturing cast silicon, comprising:
   placing a seed layer of monocrystalline silicon seed crystals on at least one surface in a crucible such that a center seed crystals of the seed layer have one primary crystal pole direction and cover about 50% to about 99% of a seed layer area, while seed crystals on an edge of the layer have at least one different crystal pole direction and cover a remaining area;
   introducing feedstock silicon and bringing the feedstock silicon and some of the layer to a molten state;
   forming a solid body of silicon by extracting heat through the seed layer and a portion of the crucible contacting the seed layer;
   bringing the solid body to a first temperature; and
   cooling the solid body to a second temperature.
30. A method of manufacturing cast silicon, comprising:
   placing at least one monocrystalline seed crystal of at least about 10 cm by about 10 cm area on a bottom of a crucible;
   placing liquid silicon in contact with the at least one seed crystal;
   forming a solid body of silicon by extracting heat through the seed crystal in such a way that a convex solid boundary increases a cross-sectional area of monocrystalline growth;
   bringing the solid body to a first temperature, and cooling the body to a second temperature;
   cutting a slab from a side of the solid body opposite the seed crystal;
   cleaning the slab using a chemical process; and
   using the slab as a seed layer for a subsequent casting process.

## Claims

1. A body ofbi-crystal silicon being free or substantially free of radially-distributed impurities and defects, and having at least two dimensions that are each at least 25 cm and a third dimension at least 20 cm.

2. A body according to claim 1 having a carbon concentration of about 2x10¹⁶ atoms/cm³ to about 5x10¹⁷ atoms/cm³, an oxygen concentration not exceeding 5x10¹⁷ atoms/cm³, and a nitrogen concentration of at least 1x10¹⁵ atoms/cm³

3. The body according to claim 1, wherein the body is free or substantially free of swirl defects and substantially free of oxygen-induced stacking fault defects.

4. The body according to claim 1, wherein the continuous cast bi-crystal silicon comprises at least two dimensions each at least about 35 cm.

5. A method of manufacturing a solar cell, comprising:
manufacturing a body of bi-crystal silicon as claimed in any of claims 1 to 4;
forming one or more wafers from the body of bi-crystal silicon, each wafer comprising a p-n junction; and
forming the one or more wafers into a solar cell comprising electrically conductive contact on the wafer.

6. A method of manufacturing a silicon wafer, comprising:
Manufacturing a body of bi-crystal silicon as claimed in any of claims 1 to 4 and cutting wafers from the body.

7. A method according to claim 5 or claim 6, wherein the body of bi-crystal silicon is a body of continuous cast bi-crystal silicon.

8. A method according to any of claims 5 to 7, wherein the one or more wafers each have at least one dimension that is at least about 50 mm.
